# EUROPEAN PATENT APPLICATION

(11) **EP 1 953 260 A1**
(43) Date of publication of application: **06.08.2008**
(21) Application number: 06822600.0
(22) Date of filing: 30.10.2006
(51) Int. Cl.: C23C 16/30, B23B 27/14, B23B 51/00, B23C 5/16

(54) **SURFACE-COATED MEMBER, METHOD FOR MANUFACTURE THEREOF, AND CUTTING TOOL**

(30) Priority: 28.10.2005 JP 2005314105; 28.10.2005 JP 2005314273
(71) Applicant: Kyocera Corporation, Kyoto-shi Kyoto 612-8501 (JP)
(72) Inventor: FUKANO, Tsuyoshi, Satsumasendai-shi, Kagoshima 895-0211 (JP); ITOH, Hirotoshi, Satsumasendai-shi, Kagoshima 895-0211 (JP)
(74) Representative: HOFFMANN EITLE
(86) International application number: PCT/JP2006/321643
(87) International publication number: WO 2007/049785

(57) **Abstract**

A surface coated member and its manufacturing method are provided. The member has a substrate and a coating layer on the substrate surface. A plurality of first phases and a second phase exist in the coating layer surface. The first phases are composed of at least one compound containing at least one element selected from metals in Groups 4, 5 and 6 of the periodic table, aluminum and silicon, and oxygen. The second phase is composed of at least one compound selected from carbide, nitride and carbon nitride of at least one element selected from the abovementioned metals, aluminum and silicon. A cutting tool includes the surface coated member and has a rake face on the upper surface, a flank face on the side surface, and a cutting edge at a crossed ridge portion between the rake face formed by at least the coating layer surface, and the flank face.

## Description

### TECHNICAL FIELD

The present invention relates to a surface coated member whose substrate surface is coated with a coating layer having excellent properties such as fracture resistance, welding resistance and wear resistance. The surface coated member can be used in cutting tools, sliding members, metal molds and the like. The present invention also relates to a method of manufacturing the surface coated member, and a cutting tool.

### BACKGROUND ART

Conventionally, in cutting metals such as cast iron, carbon steel and stainless steel, a surface coated cutting tool (hereinafter referred to simply as a cutting tool) is widely used, in which a hard coating film (that is, a hard coating layer, hereinafter referred to simply as a coating layer) having excellent mechanical hardness composed of a titanium-based compound, such as titanium carbide, titanium nitride or titanium carbonitride, is formed by welding on a substrate surface composed of a cemented carbide such as tungsten carbide-based cemented carbide or titanium-based cermet.

Recently, in consideration of high speed cutting, the handling of work materials called hard-to-cut materials, and environment, there is a desire for dry cutting without coolant. Since the surface temperature of the cutting tool is remarkably increased, the coating layer on the cutting tool surface is subjected to high temperature and oxidation, and the wear resistance thereof will gradually deteriorate with the progress of the oxidation. The chips of a work material are repetitively welded and removed in the vicinity of the cutting edge of the cutting tool. The shock at that time may cause a portion of the cutting edge to be broken, which is called chipping. This may further contribute to fracture causing a breakage of the cutting edge and therearound, which is larger than the chipping. As a result, the dimensional accuracy of the cutting is deteriorated, and the cut surface may be damaged, shortening the life of the cutting tool.

Consequently, the cutting tools are required to have both wear resistance and welding resistance. In order to meet this requirement, for example, Patent Document No. 1 describes that a coating layer composed of an oxide, particularly a coating layer composed of Al₂O₃ has excellent oxidation resistance and high wear resistance. Patent Document No. 1 also describes a cutting tool having an improved welding resistance of Al₂O₃ attained by controlling the surface roughness of an Al₂O₃ layer to a predetermined value or less, as well as the excellent wear resistance of Al₂O₃.
However, the cutting tool described in Patent Document No. 1 fails to sufficiently suppress welding properties due to seizure with increasing cutting speed or the like.

Patent Document No. 2 describes that a titanium nitride layer has low reactivity with work materials such as iron, and has excellent welding resistance.
However, the cutting tool described in Patent Document No. 2 fails to sufficiently suppress tool wear, such as the crater wear of the rake face, with increasing the tool surface temperature due to high speed cutting.

Patent Document No. 3 describes that titanium nitride or the like is exposed onto the tool surface in order to improve the seizure resistance and welding resistance of oxides, particularly Al₂O₃.
However, the cutting tool described in Patent Document No. 3 has insufficient wear resistance in the region subjected to friction with the work material on the rake face, particularly the region susceptible to crater wear, such as the breaker surface.

Meanwhile, as a method of forming a coating layer, there is physical vapor deposition (PVD) method. In the PVD method, a metal material as a vapor source is attached to the cathode, and the metal material is evaporated and ionized by arc discharge, glow discharge, sputtering ion irradiation or the like. The ions of the metal material are then allowed to react with nitrogen gas, carbon-containing gas (such as methane and acetylene) and oxygen gas admitted into the apparatus, thereby coating thin layers of materials such as metal nitride, metal carbide and metal oxide on the substrate surface.

It is however known that metallic element coarse particles called droplets are present in the coating layer coated by the PVD method (for example, the coating layer formed by arc ion plating method). These coarse particles can be formed in the following manner. That is, coarse evaporated particles are generated by arc discharge, glow discharge and the like locally concentrating on the evaporation source surface, and these particles remain adhered to and deposited on the surface of the coating layer. These metallic element coarse particles may have a dimension of several µm to several tens µm.

Since cutting is the process of transferring the surface shape of the cutting tool to a work material, the deterioration of the surface roughness of the cutting tool surface due to the adhesion of coarse particles leads the accuracy of the finished surface of the work material to be deteriorated. Further, the separation of the coarse particles from the coating layer surface during the cutting may cause a considerable unevenness in the coating layer surface, increasing cutting resistance. Therefore, the accuracy of the finished surface of the work material is deteriorated to cause burr, and the coating layer is apt to partially peel from the substrate surface. As a result, deteriorating the wear resistance and fracture resistance of the cutting tool deterirate.

For example, Patent Document No. 4 describes a coated tool in which a substrate is coated with a hard layer (a coating layer) having predetermined microholes, and the outermost layer of the hard layer is coated by PVD method. Patent Document No. 5 describes a coating tool in which a coating layer having predetermined pores is coated on the substrate surface by PVD method. Patent Document No. 6 describes a wear-resistant lubricant layer coated member having a substrate coated with a coating layer in which predetermined recessed portions are scattered.

It can be considered that when the microholes, the pores or the recessed portions as described in these publications are present in the coating layer surface, coolant can be retained in the microholes or the like, thereby reducing cutting resistance.
However, because the coating layers described in the abovementioned publications are coated by PVD method, in view of the above problem of the coarse particles, the microholes might have a large size and hence the cutting tool has insufficient wear resistance and fracture resistance.

On the other hand, chemical vapor deposition (CVD) method is also used as a method of forming a coating layer. In the CVD method, a reactive gas is allowed to flow through a high temperature substrate so that a solid layer can be deposited on the substrate surface. For example, Patent Document No. 7 describes a coating tool in which a predetermined coating layer is coated on the substrate surface. The coating layer is coated by CVD method.

In general, the cutting tool having a hard coating layer coated by CVD method is free from the abovementioned problem of the coarse particles generated by PVD method.
However, the cutting tool having the coating layer coated by CVD method has poor coolant holding power and therefore has insufficient lubricity against work materials. As a result, there is a tendency that chips become jammed and the high temperature of the cutting edge facilitates oxidation wear. Consequently, the wear resistance and fracture resistance of this cutting tool are not necessarily sufficient.

Patent Document No. 8 describes a coated cemented carbide tool coated with a predetermined multilayer ceramic layer. The ceramic layer is coated by PVD method or CVD method.
However, the coating by PVD method has the problems of wear resistance and fracture resistance due to the abovementioned coarse particles. The coating by CVD method has the problem of poor lubricity against work materials.

Patent Document No. 1: Japanese Examined Patent Publication No. 8-18163
Patent Document No. 2: Japanese Unexamined Patent Publication No. 2004-50385
Patent Document No. 3: Japanese Unexamined Patent Publication No. 8-11005
Patent Document No.4: Japanese Unexamined Patent Publication No. 2002-146515
Patent Document No. 5: Japanese Unexamined Patent Publication No. 2045-153072
Patent Document No. 6: Japanese Unexamined Patent Publication No. 2002-38255
Patent Document No. 7: Japanese Unexamined Patent Publication No. 5-57507
Patent Document No. 8: Japanese Unexamined Patent Publication No. 8-11005

### DISCLOSURE OF THE INVENTION

### PROBLEMS TO BE SOLVED BY THE INVENTION

The main advantage of the present invention is to provide a long-life surface coated member owing to sufficient exhibition of both of welding resistance and wear resistance in high speed cutting, as well as a method of manufacturing the surface coated member, and a cutting tool.
Other advantage of the present invention is to provide a cutting tool having high lubricity against work materials and having excellent wear resistance and excellent fracture resistance.

### MEANS FOR SOLVING THE PROBLEMS

The intensive research of the present inventors has led to the present invention based on the following new finding. That is, when a plurality of specific first phases having excellent oxidation resistance and a specific second phase having excellent welding resistance are present in the surface of a coating layer to be formed on a substrate surface, the coating layer is capable of having both of oxidation resistance and welding resistance, so that both of welding resistance and wear resistance can be sufficiently exhibited in high speed cutting, permitting a long life.

The surface coated member of an embodiment of the invention has a substrate and a coating layer to be formed on a surface of the substrate. A plurality of first phases and a second phase are present in the surface of the coating layer. The plurality of first phases are composed of at least one compound containing at least one element selected from the group consisting of metals in Groups 4, 5 and 6 of the periodic table, aluminum and silicon, and oxygen. The second phase is composed of at least one compound selected from carbide, nitride and carbon nitride of at least one element selected from the group consisting of metals in Groups 4, 5 and 6 of the periodic table, aluminum and silicon.

The method of manufacturing the above surface coated member includes the step of forming, as a layer constituting the coating layer, an under layer composed of at least one compound containing at least one element selected from the group consisting of metals in Groups 4, 5 and 6 of the periodic table, aluminum and silicon, and oxygen, on the surface of the substrate; the step of forming, as a surface layer of the coating layer, an outermost layer composed of at least one compound selected from carbide, nitride and carbon nitride of at least one element selected from the group consisting of metals in Groups 4,5 and 6 of the periodic table, aluminum and silicon; and the step of polishing the outermost layer until a plurality of first phases constituting the under layer are exposed in a second phase constituting the outermost layer on the surface of the coating layer.

When the above surface coated member of the present invention is used as a cutting tool, the cutting tool includes the surface coated member. The cutting tool has a rake face on an upper surface, a flank face on a side surface, and a cutting edge at a crossed ridge portion between the rake face and the flank face. The rake face is formed on at least the surface of the coating layer.

The present inventors have had the following finding by the intensive studies for solving the abovementioned problems. That is, when the surface of the coating layer coated by CVD method is ground, the surface thereof has a plurality of recessed portions. The recessed portions holding a coolant improves lubricity against a work material. By reducing the recessed portions in the coating layer surface, the fracture of the cutting edge originated from the recessed portions when the work material collides with the cutting edge (the horning portion) of the tool during the cutting can be suppressed, improving fracture resistance.

On the other hand, the coating layer surface with more recessed portions can improve the lubricity against the work material, thereby suppressing chip jamming. It is possible to suppress oxidation wear that is particularly liable to progress on the rake face of the cutting tool where a large number of chips pass through and hence the friction between the rake face and the chips raises the temperature. This permits an improvement of wear resistance.

The present inventors have made further intensive research and completed the present invention based on the following consideration. That is, when the recessed portions in a coating layer surface coated by CVD method and then ground are allowed to exist more on the rake face than on the cutting edge by partially changing the ratio of the recessed portions, it is possible to reduce the fracture of the cutting edge due to the collision of a work material against the cutting edge, and also suppress the oxidation wear on the rake face. This provides a cutting tool having high lubricity against a work material, and having excellent wear resistance and excellent fracture resistance.

That is, the cutting tool of other embodiment of the present invention includes at least one coating layer coated by CVD method on a surface of a substrate on which a cutting edge (a horning portion) is formed at a crossed ridge portion between a rake face and a flank face.
The surface of the coating layer has a plurality of recessed portions, and the area ratio of the recessed portions is greater on the rake face than on the cutting edge.

### EFFECT OF THE INVENTION

In the surface coated member of the present invention, the plurality of specific first phases and second phase coexist in the coating layer surface, thus enabling exhibition of high oxidation resistance and high welding resistance. Specifically, the first phases have excellent oxidation resistance, and the second phase has excellent welding resistance. Under the coexistence of these two types of phases on the coating layer surface, the coating layer surface can have both of the oxidation resistance of the first phase and the welding resistance of the second phase. Therefore, the progress of tool wear such as crater wear can be suppressed by the excellent oxidation resistance of the first phases, and the welding of the work material due to seizure or the like, and the layer peeling and tool fracture can be suppressed by the excellent welding resistance of the second phase. Consequently, the excellent welding resistance against the work material permits an improvement of chip discharge properties, and produces a significant effect in continuous cutting of work materials, particularly steels (i.e. hard-to-cut materials).

When the surface coated member of the invention is used as a cutting tool, the rake face is formed on at least the surface of the coating layer, and the progress of crater wear can be suppressed by the excellent wear resistance. Further, owing to the excellent welding resistance, it is possible to improve chip discharge properties and reduce the fracture of the cutting edge such as layer peeling and cutting edge chipping due to the welding of a work material. This leads to the excellent cutting tool having a long tool life which can endure the use in high speed cutting and dry cutting.

In the cutting tool of other embodiment of the invention, when the recessed portions in the surface of a coating layer coated by CVD method and then ground are allowed to exist more on the rake face than on the cutting edge (the horning portion), it is possible to reduce the fracture of the cutting edge originated from the recessed portions existing in the cutting edge, and also suppress the oxidation wear on the rake face. This leads to the cutting tool having high lubricity against work materials, as well as excellent wear resistance and excellent fracture resistance.

### BRIEF DESCRIPTION OF THE DRAWINGS

Fig. 1 is a perspective view showing a cutting tool according to a first preferred embodiment;
Fig. 2 is an enlarged sectional view of the cutting tool taken along the line A-A in Fig. 1;
Fig. 3(a) is an enlarged explanatory drawing showing a coating layer surface on the breaker surface in the first preferred embodiment; and Fig. 3(b) is an enlarged explanatory drawing showing the coating layer surface on the land surface;
Fig. 4 is an enlarged sectional view showing the coating layer surface and its surroundings in the first preferred embodiment;
Fig. 5 is an enlarged sectional view showing other example of the breaker surface and the land surface;
Fig. 6 is an enlarged sectional view showing still other example of the breaker surface and the land surface;
Fig. 7 is an enlarged sectional view showing the coating layer surface and its surroundings in a second preferred embodiment;
Fig. 8 is a scanning electron microscope (SEM) photograph (magnification x3000) showing the coating layer surface of the cutting edge in the second preferred embodiment;
Fig. 9 is an SEM photograph (magnification x3000) showing the coating layer surface of the land surface in the second preferred embodiment;
Fig. 10 is an explanatory drawing showing an example of a method of manufacturing work pieces according to the present invention;
Fig. 11 is a perspective view showing other example of a method of manufacturing work pieces according to the present invention; and
Fig. 12 is an SEM photograph (magnification x3000) showing the coating layer surface on the rake face of Sample No. II-6, which corresponds to the coating layer surface not subjected to polishing.

### PREFERRED EMBODIMENTS FOR CARRYING OUT THE INVENTION

Preferred embodiments where the surface coated member of the invention is used in a throwaway chip type cutting tool will be described in detail with reference to the accompanying drawings.

### First Preferred Embodiment

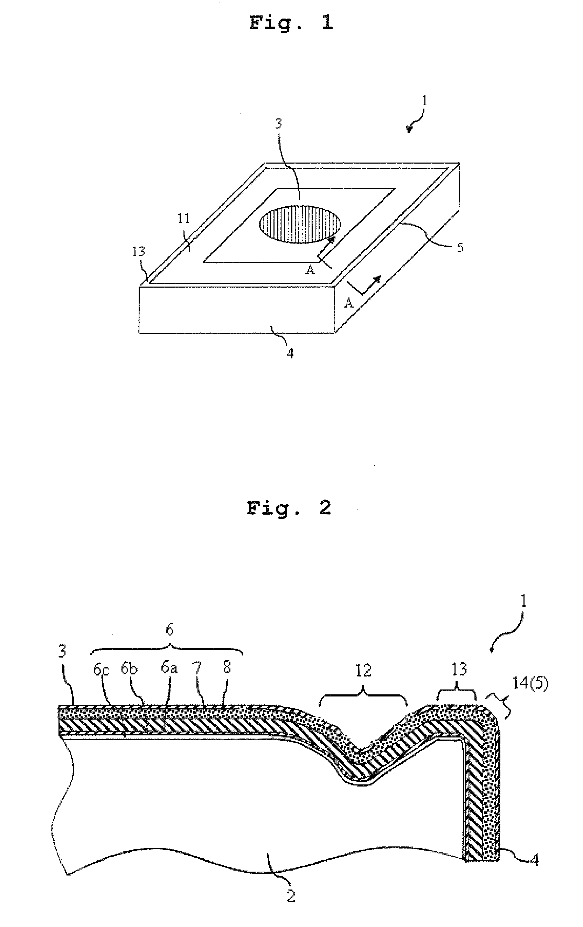

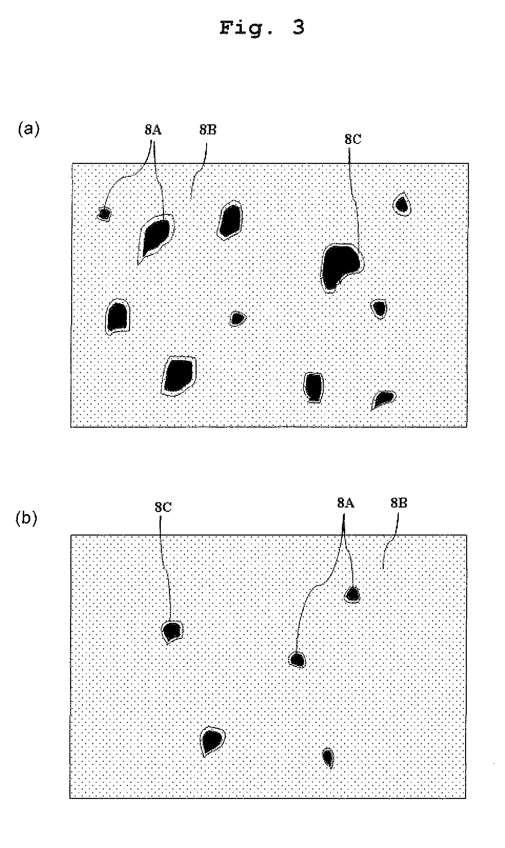

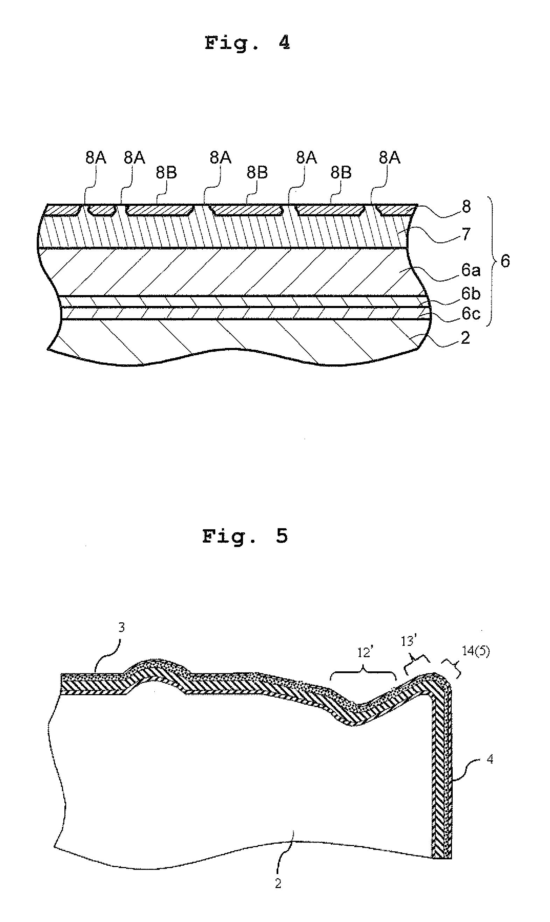

Fig. 1 is a perspective view showing a cutting tool according to a first preferred embodiment. Fig. 2 is an enlarged sectional view of the cutting tool taken along the line A-A in Fig. 1. Fig. 3(a) is an enlarged explanatory drawing showing a coating layer surface on the breaker surface in the first preferred embodiment, and Fig. 3(b) is an enlarged explanatory drawing showing the coating layer surface on the land surface. Fig. 4 is an enlarged sectional view showing the coating layer surface and its surroundings in the first preferred embodiment.

As shown in Fig. 1, a cutting tool 1 (hereinafter referred to simply as a "tool 1") has a substantially flat shape, and has a rake face 3 on a main surface (the upper surface) of a substrate 2, a flank face 4 on the side surface of the substrate 2, and a cutting edge 5 at a crossed ridge portion between the rake face 3 and the flank face 4.

The substrate 2 may be formed from cemented carbide and cermet formed by binding a hard phase and a binding phase, or ceramic sintered bodies such as silicon nitride (Si₃N₄) or aluminum oxide (Al₂O₃) based one, or hard materials such as superhard sintered body composed mainly of cubic boron nitride (cBN) or diamond; or highly hard materials such as metals, for example, carbon steel, high speed steel and alloy steel; said hard phase being composed of tungsten carbide (WC) or titanium carbide (TiC) or titanium carbonitride (TiCN) and optionally if desired, at least one selected from the group consisting of carbide, nitride and carbon nitride of metals in Groups 4, 5 and 6 of the periodic table, and said binding phase being composed of iron group metals of cobalt (Co) and/or nickel (Ni).

In the present embodiment, the substrate 2 is preferably formed from a cemented carbide consisting of a hard phase composed mainly of tungsten carbide (WC), and a binding phase composed of cobalt (Co). The substrate 2 formed from the cemented carbide achieves a good balance between hardness and toughness, and a stable cutting operation as a high speed wet cutting.

A coating layer 6 is coated on the surface of the substrate 2. As shown in Fig. 2, the coating layer 6 has a titanium nitride layer as an outermost layer 8, and an aluminum oxide layer 7 as a layer adjacent to the outermost layer 8. Further, titanium oxycarbonitride layer 6a, a titanium carbonitride layer 6b and a titanium nitride layer 6c, which are adjacent to the aluminum oxide layer 7, are arranged in the order of decreasing distance to the substrate 2. Thus, owing to the micro columnar structure of titanium carbonitride having a high aspect ratio, fracture resistance and wear resistance can be improved, and binding power can also be enhanced, exhibiting excellent peeling resistance.

It is important that a plurality of first phases 8A and a second phase 8B are present in the surface of the coating layer 6 (namely the surface of the outermost layer 8), as shown in Figs. 3(a) and 3(b). This enables the coating layer 6 to exhibit high oxidation resistance and high welding resistance. Specifically, the plurality of first phases 8A are composed of at least one compound containing at least one element selected from the group consisting of metals in Groups 4, 5 and 6 of the periodic table, aluminum and silicon, and oxygen. Examples of the metals in Groups 4, 5 and 6 of the periodic table include Ti, Zr, Hf, V, Nb, Ta, Cr, Mo and W. Examples of the above compound include aluminum oxide (Al₂O₃), titanium oxide (TiO₂), titanium oxycarbide (TiCO), titanium oxynitride (TiNO), titanium oxycarbonitride (TiCNO) and zirconium oxide (ZrO₂). These exemplified compounds have excellent oxidation resistance. Among others, aluminum oxide is preferred. Examples of the crystal structure of aluminum oxide include α-type crystal structure, κ-type crystal structure, and a mixed crystal structure of α-type and κ-type crystal structures. Among others, α-type crystal structure is preferred. These crystal structures have excellent high temperature hardness and oxidation resistance, and the aluminum oxide of α-type crystal structure has the most excellent oxidation resistance.

The second phase 8B is composed of at least one compound selected from carbide, nitride and carbon nitride of at least one element selected from the group consisting of metals in Groups 4, 5 and 6 of the periodic table, aluminum and silicon. Examples of the above compound include titanium nitride (TiN), titanium carbonitride (TiCN), titanium carbide (TiC), composite nitride containing titanium and aluminum ((Ti, Al) N), chrome nitride (CrN), molybdenum nitride (Mo₂N) and zirconium nitride (ZrN). These exemplified compounds have excellent welding resistance. Among others, titanium nitride is preferred. Since titanium nitride has a gold color, it has decorative function and becomes discolored with use. This produces the effect that it is easy to distinguish the used location of the tool.

Preferably, the plurality of first phases 8A are present in the second phase 8B in the surface of the coating layer 6. In the present embodiment, as shown in Figs. 3(a) and 3(b), the abovementioned first phases 8A and the second phases 8B are exposed so that the first phases 8A are present in the second phase 8B in the surface of the coating layer 6. That is, the first phases 8A are scattered in the surface of the coating layer 6, and the second phase 8B are present so as to surround these first phases 8A. This enables the tool 1 to exhibit high oxidation resistance and high welding resistance. Specifically, the surface of the coating layer 6 has both of the oxidation resistance of the first phase 8A and the welding resistance of the second phase 8B. Consequently, the progress of the tool wear such as crater wear can be suppressed by the excellent oxidation resistance of the first phase 8A. The welding of a work material, the layer peeling and the fracture of the tool due to seizure or the like can be suppressed by the excellent welding resistance of the second phase 8B.
In some cases, the first phase 8A and the second phase 8B might contain unavoidable impurities and the substrate compositions during the manufacturing steps, in addition to the abovementioned compound. Even so, the excellent oxidation resistance of the first phase 8A and the excellent welding resistance of the second phase 8B can be exhibited to suppress tool wear and tool fracture.

Whether a plurality of the first phases 8A and the second phase 8B are present (exposed) in the surface of the coating layer 6, or whether a plurality of the first phases 8A are present (exposed) in the second phase 8B in the surface of the coating layer 6 can be confirmed by observing the surface of the coating layer 6 (namely, the surface of the outermost layer 8) with a microscope, such as a metal microscope or a scanning electronic microscope, at a magnification of approximately ×500 to ×1500.

Preferably, the individual first phase 8 A has an area of approximately 1 to 10µm², and the number of the first phases 8A in the square area of 50µm is about 10 to 50. This enables the surface of the coating layer 6 to have both of the oxidation resistance of the first phase 8A and the welding resistance of the second phase 8B.

The plurality of first phases 8A are preferably connected to each other on the surface side of the substrate 2, in the thickness direction of the coating layer 6, as shown in Fig. 4. With this configuration, even if the coating layer 6 wears and the thickness thereof is decreased as the tool 1 is used, it is possible to maintain the surface configuration in which the first phases 8A and the second phase 8B are exposed onto the surface of the coating layer 6, enabling the tool 1 to exhibit high oxidation resistance and high welding resistance over a long period of time. As a method of forming a plurality of first phases 8A into the abovementioned predetermined configuration, there is, for example, the method of increasing the mean grain size of compound particles constituting the first phase 8A to be described later, than that of compound particles constituting the second phase 8B.

In the present embodiment, the first phases 8A are composed of aluminum oxide, and the second phase 8B is composed of titanium nitride. That is, aluminum oxide and titanium nitride coexist in the surface of the coating layer 6. This permits more effective exhibition of welding resistance and oxidation resistance. The combination of these two compounds enables the tool 1 to be manufactured easily and at low costs. The combination of the first phase 8A and the second phase 8B is not limited to the combination of the abovementioned two compounds, and other compound constituting the first phase 8A and other compound constituting the second phase 8B may be combined together, resulting in the same effect.

When the surface of the coating layer 6 (the surface of the outermost layer 8) is observed with a microscope such as a metal microscope or a scanning electron microscope, it is preferable that the first phase composed of aluminum oxide (the aluminum oxide phase) 8A and the second phase composed of titanium nitride (the titanium nitride phase) 8B be clearly separated from each other in the coating layer 6, as shown in Fig. 3(a) and 3(b). This permits sufficient exhibition of the excellent oxidation resistance of the first phases 8A and the excellent welding resistance of the second phase 8B.

Particularly, the rake face 3 is required to have both of oxidation resistance and welding resistance, and it is therefore necessary that the rake face 3 is formed from at least the surface of the coating layer 6. Specifically, the first phases 8A composed of aluminum oxide and the second phase 8B composed of titanium nitride are not locally present in the surface of the coating layer 6. That is, in the state where the plurality of the first phases 8A are present in the second phase 8B, both of the oxidation resistance and the welding resistance of the rake face 3 can be exhibited effectively. In other words, both these properties can be exhibited in the surface state where the second phase 8B is present so as to surround the plurality of the first phases 8A, as shown in Figs. 3(a) and 3(b).

Preferably, the second phase 8B composed of titanium nitride accounts for a greater area on the surface of the coating layer 6 than the first phases 8A composed of aluminum oxide. This permits more effective exhibition of the abovementioned both properties. That is, by establishing the above specific relationship between the area of the first phases 8A and the area of the second phase 8B, the second phase 8B composed of titanium nitride can exist as the main phase, thus optimizing the oxidation resistance and the welding resistance in the surface of the coating layer 6. As a result, the excellent oxidation resistance and excellent wear resistance of the first phase 8A can be exhibited under the condition that the work material welding, the layer peeling and the tool fracture can be sufficiently suppressed by the excellent welding resistance of the second phase 8B. Further, the abovementioned effect of titanium nitride, namely, the decorative function, and the effect of making it easy to distinguish the used location of the tool (for example, the corner portions and the like) can be exhibited efficiently.

Preferably, a third phase 8C is present at a boundary between the first phase 8A and the second phase 8B in the surface of the coating layer 6, and the third phase 8C is composed of titanium carbonitride, as shown in Fig. 3. This further improves the wear resistance of the coating layer 6. The reason for this can be estimated that the characteristics of titanium carbonitride (high hardness and high toughness) can be exhibited to suppress frictional wear as a factor of tool wear. In the present embodiment, as shown in Fig. 3, the third phase 8C composed of titanium carbonitride is present between the second phase 8B composed of titanium nitride and the first phase 8A composed of aluminum oxide. This configuration enables the coating layer 6 to exhibit more excellent wear resistance with respect to the region where only the first phases 8A are exposed.

Preferably, the maximum height roughness Rz in the surface of the coating layer 6 is 1.5µm or less. This permits an improvement of the smoothness of the coating layer 6, achieving excellent sliding performance and smooth chip flow. It is further preferable that the arithmetic mean roughness Ra be in the range of 0.3µm or less, in addition to the maximum height roughness Rz of 1.5µm or less. This achieves more excellent surface smoothness and effective exhibition of improved chip discharge properties. Preferably, the lower limit of the maximum height roughness Rz is not less than 0.5µm, and the lower limit value of the arithmetic mean roughness Ra is not less than 0.05µm.

The above maximum height roughness Rz and the above arithmetic mean roughness Ra can be obtained as follows. For example, three or more locations on the surface of the coating layer 6 (for example, a land surface 13) are measured with a contact type surface roughness meter or a non-contact type laser microscope, and its mean value can be used as the maximum height roughness Rz and the arithmetic mean roughness Ra, respectively. In a specific measuring method, measurements may be made according to JIS B0601'01, using a probe type surface roughness meter. If this measurement is difficult to carry out, a measuring instrument such as a non-contact type laser microscope or an atomic force microscope may be used to obtained the abovementioned values by estimating while scanning the irregular shape in the surface of the outermost layer 8 of the coating layer 6. When the probe type surface roughness meter is used to determine the surface roughtnesses (Rz, Ra), the measurements may be made under the conditions of 0.25 mm in cutoff value, 0.8mm in reference length and 0.1 mm/sec in scanning speed.

At least part of the outermost layer 8 is preferably ground. That is, as described above, the coating layer 6 has a titanium nitride layer as the outermost layer 8, and an aluminum oxide layer 7 as a layer adjacent to the outermost layer 8. Therefore, by polishing at least part of the outermost layer 8, a plurality of the aluminum oxide layer 7 can be exposed onto the outermost layer 8. As a result, in the surface of the coating layer 6 (namely the surface of the outermost layer 8), a plurality of the first phases 8A (aluminum oxide) are exposed, and the second phase 8B (titanium nitride) is exposed so as to surround the first phases 8A. This further improves the sliding performance on the surface of the coating layer 6 and achieves smooth chip flow, improving chip discharge properties.

As a polishing method of the outermost layer 8, there are, for example, blast processing, (elastic) grindstone, and brush. These polishing methods are suitable because they have good productivity and enable the entire region of the surface of the tool 1 to be ground. Especially, when the outermost layer 8 is ground by brushing process using diamond grains and a dot brush or a wheel brush, it is possible to perform sufficient polishing through the bottom of a breaker surface 12 to be described later, thereby uniformly improving the smoothness of the outermost layer 8

In some cases, the manufacturing steps of the tool 1 includes the step of polishing after the step of forming the aluminum oxide layer 7 and the titanium nitride layer (the outermost layer 8). In this case, the mean grain size of aluminum oxide used for forming the aluminum oxide layer 7 is preferably greater than that of titanium nitride used for forming the titanium nitride layer. That is, the mean grain size of aluminum oxide particles constituting the first phase 8A is preferably greater than that of titanium nitride particles constituting the second phase 8B. This produces proper concaves and convexes in the surface of the aluminum oxide layer 7 during the layer forming process. Therefore, when the titanium nitride layer (the outermost layer 8) is formed thereon, the titanium nitride particles are apt to enter into the concaves in the proper concaves and convexes of the aluminum oxide layer 7. In this state, the polishing of the outermost layer 8 facilitates to form the surface configuration that a plurality of the first phases 8A composed of aluminum oxide are exposed, and the second phase 8B composed of titanium nitride is exposed so as to surround the first phases 8A in the surface of the coating layer 6 (namely the surface of the outermost layer 8). The abovementioned action can be obtained effectively when the mean grain size of the aluminum oxide particles is in the range of 1.0 to 3.0µm, and the mean grain size of the titanium nitride particles is in the range of 0.01 to 1.0µm.
The abovementioned mean grain sizes may be measured from observation images obtained by using a transmission electron microscope or the like at a magnification ×200,000 to ×2,000,000.

As shown in Fig. 2, the tool 1 is provided with the breaker surface 12 on the rake face 3 in order to stabilize chip flow and improve chip discharge properties. Specifically, the rake face 3 has the land surface 13 adjacent to the cutting edge 5, and the breaker surface 12 adjacent to the land surface 13. In the cutting tool having such a breaker surface, the friction with chips will particularly become large on the breaker surface 12, and apt to wear. The breaker surface 12 is therefore strongly required to have oxidation resistance and wear resistance.

On the other hand, the land surface 13 is apt to be damaged such as a work material welding, the layer peeling due to the welding, the cutting edge chipping and fracture, because large friction stress occurs on the face surface 3. The disadvantage of the land surface 13 to be caused by the fracture or the like is not limited to the land surface 13, and cracks may reach the adjacent cutting edge 5 and further to the flank face 4. As a result, the flank wear might occur. The land surface 13 is therefore required to have welding resistance, namely peeling resistance and fracture resistance.

Hence, in the present embodiment, as shown in Figs. 3(a) and 3(b), the area ratio of the first phase 8A composed of aluminum oxide on the face surface 3 is greater on the breaker surface 12 than on the land surface 13. This enables effective exhibition of the characteristics required in the abovementioned respective regions on the rake face 3. Specifically, on the breaker surface 12 whose surface temperature is high due to the friction with chips and is apt to cause oxidation reaction, the ratio of the first phase 8A composed of aluminum oxide is greater than that on the land surface 13, thus achieving excellent oxidation resistance and suppression of crater wear. On the other hand, on the land surface 13 on which the cutting temperature is not so high as the rake face 3, and which is susceptible to a work material welding, the layer peeling and seizure due to the welding, and fracture, the ratio of the second phase 8B composed of titanium nitride is greater than that on the breaker surface 12, thus achieving excellent welding resistance and suppression of the work material welding, the layer peeling and the fracture. This permits the cutting tool having excellent tool life.
Particularly, the area ratio of the first phase 8A on the land surface 13 is preferably 0.1 to 30, and the area ratio of the first phase 8A on the breaker surface 12 is preferably 1 to 50. This produces the abovementioned effects.

The term "the breaker surface 12" means the surface having breaker function, and corresponds to the region of the tool surface which is subjected to large friction with chips and susceptible to crater wear. Specifically, as shown in Figs. 1 and 2, when the breaker is formed as a recess on rake face 3, the wall surface of the breaker recess is served as the breaker surface 12.

The term "the land surface 13" means a so-called land region which is adjacent to a region 14 (a horning portion) after being subjected to the reinforcement process of a cutting edge, and which extends substantially flat toward the center of the rake face 3. Specifically, when the breaker surface 12 is formed as the recess on the rake face 3, as shown in Fig. 2, the land surface 13 corresponds to the region of the rake face 3 continuously extends from the region 14 (the horning portion) subjected to the cutting edge reinforcement process to the breaker surface 12.

The abovementioned area ratio can be calculated, for example, by obtaining an observation image at a magnification ×500 to ×1000 with a metal microscope, and then calculating the observation image by using commercially available image analysis software. More specifically, the area ratio can be calculated by using, for example, "LUZEX Series," an image analyzer manufactured by NIRECO Corporation. The area ratio of the first phase 8A composed of aluminum oxide is obtained by calculating the area of the first phase 8A that exists in an arbitrary area of 10000µm² in the respective regions.

In the measurements of the area ratios, the breaker surface 12 and the land surface 13 are not necessarily limited to the surfaces defined as the above two regions, respectively. The measurements may be made on an easy-to-measure region on a flat surface having the function required in the respective regions.

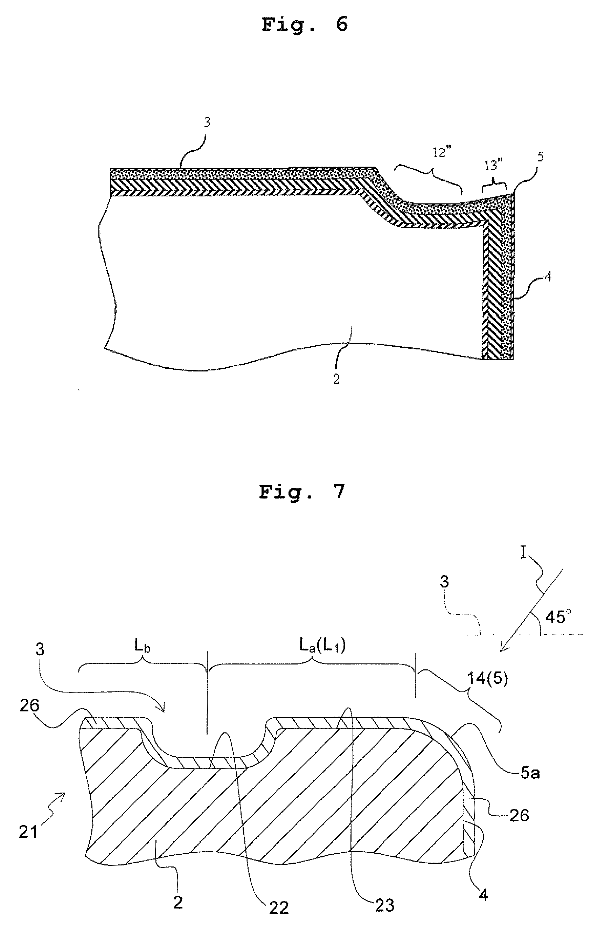

Although in the foregoing preferred embodiment, those having the construction as shown in Fig. 2 are exemplified as the breaker surface 12 and the land surface 13, the breaker surface and the land surface according to the present invention are not limited thereto. For example, these may be replaced with those shown in Figs. 5 and 6. Figs. 5 and 6 are enlarged sectional views showing other examples of the breaker surface and the land surface, respectively. Both examples show the cases where the land surface and the breaker surface are integrally formed. Specifically, Fig. 5 shows the case after being subjected to horning process, and Fig. 6 shows the case not being subjected to horning process.

That is, the breaker surface 12 may be replaced with a breaker surface 12' shown in Fig. 5, or a breaker surface 12" shown in Fig. 6. The land surface 13 may be replaced with a land surface 13' shown in Fig. 5, or a land surface 13" shown in Fig. 6. More specifically, when the land surface and the breaker surface are integrally formed adjacent to the cutting edge 5, as shown in Fig. 5, the land surface 13' corresponds to the region which is a substantially flat region between the breaker surface and the region 14 after being subjected to the cutting edge reinforcement process. In the case of the tool shape shown in Fig. 6, the land surface corresponds to the region in the vicinity of the cutting edge 5. Similarly to the case of Fig. 5, the land 13" corresponds to the region which is a substantially flat region between the cutting edge 5 and the breaker surface.

The breaker surface 12 may be any region performing chip curling action. Unlike Fig. 2, it may have the shape including a breaker bottom surface as the breaker surface, as shown in Fig. 7, without limiting to the abovementioned shape. The land surface 13 may be any region formed for maintaining the cutting edge strength, without limiting to the abovementioned shape. For example, the land surface 13 may not be a flat region, such as a curved surface, as long as the abovementioned effect can be obtained.

Next, the method of manufacturing the abovementioned tool 1 according to the first preferred embodiment will be described below. Firstly, a mixture is obtained by properly mixing metal powder, carbon powder and the like into inorganic powder such as metal carbide, nitride, carbonitride, oxide or the like, which can form the abovementioned cemented carbide by sintering. The mixture is then formed in a predetermined tool shape by a known forming method such as press forming, casting forming, extrusion forming, or cold isostatic hydraulic press forming, followed by sintering in vacuum or nonoxidizing atmosphere, resulting in a substrate 2 composed of the abovementioned hard material. To a portion of the substrate 2 which corresponds to a cutting edge 5, cutting edge reinforcement process (homing process) is applied from the rake face by using a brush and a grindstone, thereby forming a region 14 (a horning portion) after subjected to the cutting edge reinforcement process.

Subsequently, for example, with CVD method, a coating layer 6 is formed on the surface of the substrate 2 thus obtained. The method of the present embodiment includes the step of forming, on the surface of the substrate 2, as a layer constituting the coating layer 6, an under layer 7 composed of at least one compound containing at least one element selected from the group consisting of metals in Groups 4, 5 and 6 of the periodic table, aluminum and silicon, and oxygen, that is, an aluminum oxide layer; and the step of forming, as a surface layer of the coating layer 6, an outermost layer 8 composed of at least one compound selected from carbide, nitride and carbonitride of at least one element selected from the group consisting of metals in Groups 4, 5 and 6 of the periodic table, aluminum and silicon, that is a titanium nitride layer.

Preferably, the aluminum oxide particles constituting the aluminum oxide layer 7 have a greater mean grain size than the titanium nitride particles constituting the titanium nitride layer (the outermost layer 8). As described above, this produces proper concaves and convexes on the surface of the aluminum oxide layer 7, and the titanium nitride particles are apt to enter into these concaves. Therefore, by the polishing process to be described later, it is easy to form, in the surface of the coating layer 6, the surface configuration that a plurality of the first phases 8A composed of aluminum oxide are exposed in the second phase 8B composed of titanium nitride, that is, the surface configuration that a plurality of the first phases 8A composed of aluminum oxide are exposed and the second phase 8B composed of titanium nitride is exposed so as to surround the first phases 8A.

There are, for example, the following conditions for forming the abovementioned aluminum oxide layer 7 and the titanium nitride layer (the outermost layer 8). That is, the aluminum oxide (Al₂O₃) layer 7 is preferably formed by using, as a reaction gas composition, a mixed gas composed of, for example, 3 to 20% by volume of aluminum chloride (AlCl₃) gas, 0.5 to 3.5% by volume of hydrogen chloride (HCl) gas, 0.01 to 5.0% by volume of carbon dioxide (CO₂) gas, 0 to 0.01 % by volume of hydrogen sulfide (H₂S) gas, and the rest which is hydrogen (H₂) gas. The layer is preferably formed under the conditions of 30 to 50L/min in the flow rate of the mixed gas, and at 1000 to 1100°C and 5 to 10kPa. This enables formation of the aluminum oxide layer 7 having a large grain size. The aluminum oxide layer may have a different crystal form, either α-Al₂O₃ layer or κ-Al₂O₃ layer, depending on the type of the under layer formed immediately before.

Thereafter, the titanium nitride (TiN) layer as the outermost layer 8 is preferably formed by using, as a reaction gas composition, a mixed gas composed of, for example, 0.1 to 10% by volume of titanium chloride (TiCl₄) gas, 0 to 60% by volume of nitrogen (N₂) gas and the rest which is hydrogen (H₂) gas. The titanium nitride layer is preferably formed in a chamber having a furnace temperature of 800 to 1000°C and a pressure of 5 to 85kPa. This enables formation of the titanium nitride layer 7 having a small grain size.

Subsequently, the method of the present embodiment includes the step of polishing the outermost layer 8 until a plurality of the first phases 8A constituting the under layer (the aluminum oxide layer 7) are exposed in the second phase B constituting the outermost layer 8 (the titanium nitride layer) on the surface of the coating layer 6. This makes it easy to manufacture the tool 1 having both of excellent welding resistance and excellent wear resistance, and exhibiting excellent sliding performance owing to the smoothness of the member surface.

As a polishing method, there is the same polishing method as exemplified above in the polishing method of the outermost layer 8. Particularly, the outermost layer 8 is preferably ground by brushing process using diamond grinds of #100 to 1600, and more preferably brushing process using diamond grinds of #500 or finer ones. This enables the particles of the aluminum oxide layer 7 as the adjacent under layer to be exposed onto the surface of the titanium nitride layer as the outermost layer 8. It is therefore possible to achieve the surface configuration that a plurality of the first phases 8A composed of aluminum oxide are exposed in the second phase 8B composed of titanium nitride, that is, the surface configuration that a plurality of the first phases 8A composed of aluminum oxide are exposed and the second phase 8B composed of titanium nitride is exposed so as to surround the first phases 8A.

The brush projection length in the brushing process is preferably 1 to 7cm, particularly 1 to 5cm. Even when the tool has a concave-convex shape, such as having the breaker surface 12, the surface of the outermost layer 8 can be ground every nook and corner, without leaving any non-ground portion at the corners having the concave-convex shape. As a result, the surface of the tool 1 can have a uniform surface roughness, and the first phase 8A composed of aluminum oxide can be properly exposed and scattered over the entire surface of the tool 1.

Preferably, the method of the present embodiment includes the step of forming a titanium carbonitride layer as an inner layer adjacent to the titanium nitride layer (the outermost layer 8); and the step of polishing until at least a part of a third phase 8C composed of titanium carbonitride particles constituting the titanium carbonitride layer is exposed onto the surface of the coating layer 6. Thus, the surface of the coating layer 6 can be smoothed, exhibiting excellent sliding performance. Additionally, the characteristics of titanium carbonitride (high hardness and high toughness) can be exhibited to suppress frictional wear as a factor of tool wear.

The abovementioned titanium carbonitride layer is preferably formed by using, as a reaction gas composition, a mixed gas composed of, for example, 0.1 to 3% by volume of titanium tetrachloride (TiCl₄) gas, 0.1 to 60% by volume of nitrogen (N₂) gas, 0.1 to 10% volume of methane (CH₄) gas and the rest which is hydrogen (H₂) gas, at a furnace temperature of 800 to 1100°C and a furnace pressure of 5 to 85kPa.

In the present embodiment, the titanium oxycarbonitride layer 6a, the titanium carbonitride layer 6b and the titanium nitride layer 6c, which are adjacent to the aluminum oxide layer 7, are arranged in the order of decreasing distance to the substrate 2. For example, these layers can be formed under the following conditions.

That is, the titanium oxycarbonitride layer 6a is preferably formed by using, as a reaction gas composition, a mixed gas composed of, for example, 0.1 to 3% by volume of titanium tetrachloride (TiCl₄) gas, 0.1 to 60% by volume of nitrogen gas (N₂), 0.1 to 10% by volume of methane (CH₄) gas, 0.3 to 1.2% by volume of carbon dioxide (CO₂) gas and the rest which is hydrogen (H₂) gas, at a furnace temperature of 800 to 1100°C and a furnace pressure of 5 to 85kPa.

The titanium carbonitride layer 6b is preferably formed by using, as a reaction gas composition, a mixed gas composed of, for example, 0.1 to 3% by volume of titanium tetrachloride (TiCl₄) gas, 0.1 to 60% by volume of nitrogen (N₂) gas, 0.1 to 10% by volume of methane (CH₄) gas, 0.3 to 1.2% by volume of carbon dioxide (CO₂) gas and the rest which is hydrogen (H₂) gas, at a furnace temperature of 800 to 1100°C and a furnace pressure of 5 to 85kPa.
The titanium nitride layer 6c may be formed under the same conditions as exemplified in the titanium nitride (TiN) layer constituting the outermost layer 8.

Although the method of forming the coating layer 6 by CVD method has been described in the first preferred embodiment, the method of manufacturing the tool 1 of the present invention is not limited to the above method. Other layer forming method such as PVD method may be used to form the coating layer 6. Also in this case, the grain size of the outermost layer 8 can be optimized by controlling the flow rate of layer forming gas and the layer forming temperature. Further, the polishing of the outermost layer 8 by the abovementioned process enables a plurality of the first phases 8A composed of aluminum oxide to be exposed in the second phase 8B composed of titanium nitride on the surface of the coating layer 6. That is, it is possible to achieve the surface configuration that a plurality of the first phases 8A composed of aluminum oxide are exposed and the second phase 8B composed of titanium nitride is exposed so as to surround the first phases 8A in the surface of the coating layer 6.

As a method of allowing aluminum oxide and titanium nitride to coexist in the surface of the coating layer 6, for example, a layer composed of a mixture of an aluminum oxide material and a titanium nitride material may be formed instead of the abovementioned manufacturing method.

### Second Preferred Embodiment

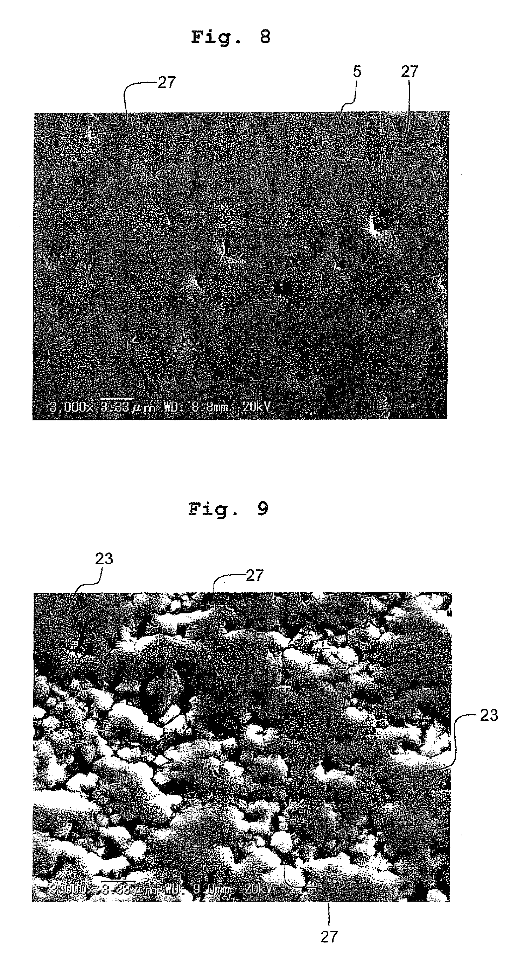

A cutting tool according to a second preferred embodiment will be described in detail with reference to the accompanying drawings. Fig. 7 is an enlarged sectional view showing a coating layer surface and its surroundings in the present embodiment. Fig. 8 is a scanning electron microscope (SEM) photograph (magnification x3000) showing the coating layer surface of the cutting edge (a horning part) in the present embodiment. Fig. 9 is an SEM photograph (magnification ×3000) showing the coating layer surface of the land surface in the present embodiment. In Figs. 7 to 9, the same reference numerals have been used for identical or similar components in the abovementioned configurations shown in Figs. 1 to 6, with the description thereof omitted.

In the cutting tool of the present embodiment, a coating layer is coated on the substrate surface by CVD method, and the number of a plurality of recessed portions existing on the coating layer surface is greater on the rake face than on the cutting edge (the horning part). Specifically, as shown in Fig. 7, in a cutting tool 21 of the present embodiment, a cutting edge 5 is formed at a crossed ridge portion between a rake face 3 and a flank face 4, and the region of the cutting edge 5 extending from the rake face 3 to the flank face 4 including the crossed ridge portion is ground to remove the tip of the cutting edge 5, thereby forming a horning part (a chamfering part), namely a region 14 (the horning part) after being subjected to cutting edge reinforcement process. A coating layer 26 is coated on the surface of a substrate 2.

The rake face 3 has a breaker surface 22 and a land surface 23. As described in the first preferred embodiment, the breaker surface 22 improves chip discharge properties. Even when cutting conditions such as cutting depth and feed are changed, chips can be discharged through the land surface 23, achieving suitable chip sliding and stable chip discharge. In the second preferred embodiment shown in Fig. 7, the bottom of the breaker surface 22 is formed flat. As described in the first preferred embodiment, the present invention is not limited thereto, and the bottom of the breaker surface 22 may be a curved surface instead of the flat surface.

Although the coating layer 26 has the same layer configuration as the coating layer 6 of the first preferred embodiment, the coating layer 26 of the second preferred embodiment is not limited thereto, and it may have any layer configuration which can be formed by CVD method. Specifically, the layer configuration may consist of carbide, nitride, boride or oxide of at least a metal element selected from the group consisting of metals in Groups 4a, 5a and 6a of the periodic table, aluminum and silicon, or alternatively a composite compound of these. Examples of the composite compound include compounds containing two or more types of the abovementioned metals, carbonitride, carbon oxide, nitrogen oxide and oxycarbonitride. Specific examples include TiN, TiC, TiCN, TiCNO, TiAIN, α-Al₂O₃ and κ-Al₂O₃.

When the coating layer 26 has a layer configuration other than that of the coating layer 6 of the first preferred embodiment, it may consist of at least one layer. Alternatively, the coating layer 26 may consist of a plurality of layers, such as 1 to 1 0 layers, preferably 3 to 7 layers. Any number of layers may be used depending on the purpose.

The coating layer 26 is formed by CVD method. The surface of the coating layer 26 is ground so as to smoothen at least the surface of the coating layer 26 which includes the rake face 3 and the cutting edge 5 (the horning part), and which has a plurality of recessed portions 27. That is, as shown in Figs. 8 and 9, a large number of the recessed portions 27 are scattered in the surface of the coating layer 26. In the present invention, the term "recessed portions" means micro recessed portions to be scattered in the surface of the coating layer formed by CVD method by polishing the surface of the coating layer. The recessed portions can hold a coolant, thereby improving lubricity against work material.

As a method of polishing the surface of the coating layer 26, there are, for example, barrel polishing, electrolytic polishing, or alternatively polishing by cutting, sputtering process and bombardment process using a PVD apparatus, in addition to the same polishing methods as exemplified in the method of polishing the outermost layer 8 in the first preferred embodiment.

As shown in Figs. 8 and 9, a larger number of the recessed portions 27 are scattered on the land surface 23 (the rake face 3) than on the cutting edge 5 (the horning part). That is, it is arranged so that the area ratio of the plurality of the recessed portions 27 becomes larger on the rake face 3 than on the cutting edge 5. This reduces the fracture of the cutting edge due to the recessed portions scattered in the cutting edge 5, and also suppresses the oxidation wear of the rake face 3.

In the present embodiment, the area ratio of the recessed portions 27 in a region Lₐ between the end on the rake face 3 of the cutting edge 5 and the bottom of the breaker surface 22 is preferably greater than that of the recessed portions 27 in the cutting edge 5. Particularly, the area ratio of the recessed portions 27 in the region Lₐ between the end on the rake face 3 of the cutting edge 5 and the bottom of the breaker surface 22 is 10 to 50%, preferably 25 to 45%. The area ratio of the recessed portions 27 in the cutting edge 5 is 2 to 40%, preferably 2 to 15%. When the recessed portions 27 are more scattered in the rake face 3 than in the cutting edge 5 at the abovementioned area ratio, the cutting tool 21 has more excellent wear resistance and fracture resistance.

Specifically, when the area ratio of the recessed portions 27 in the region Lₐ between the end on the rake face 3 of the cutting edge 5 and the bottom of the breaker surface 22 is 10% and above, oxidation resistance can be suppressed without hindering the lubricity of the rake face 3 against work material. When it is 50% or less, it is possible to suppress that the layer strength of the coating layer 26 is lowered, deteriorating wear resistance. When the area ratio of the recessed portions 27 in the cutting edge 5 is 2% and above, it is possible to suppress the progress of oxidation wear due to a remarkable temperature rising of the cutting edge 5. When it is 40% or less, it is possible to suppress that fracture occurs under the impact of the work material during the cutting.

The area ratio of the recessed portions 27 in the region Lₐ between the end on the rake face 3 of the cutting edge 5 and the bottom of the breaker surface 22 can be measured in the region extending from the end on the rake face 3 of the cutting edge 5 to the distance of (1/4) L₁ where L₁ is the distance between the end on the rake face 3 of the cutting edge 5 and the bottom of the breaker surface 22. The recessed portions 27 in the cutting edge 5 can be measured in the middle region of the cutting edge 5.
The abovementioned area ratio can be obtained as follows. As will be described later, for example, the surface of the coating layer 26 is observed at magnification × 1000 to x3000 by a scanning electron microscope (SEM) or an optical microscope, and the observed image data are digitalized. The image data are then subjected to computer image processing, thereby obtaining the total area of the recessed portions 27 in the image. From this image, the respective areas of the recessed portions 27 in the region Lₐ, the region extending to the distance of cutting edge 5 and (1/4)L₁, and the middle region of the cutting edge 5 are obtained, and the ratio of these areas to the total area is calculated. The digitalization of the image data and the computer image processing of the image data can be performed by using, for example, image analysis software "imagePROGRAF" manufactured by Planetron, Inc.
The abovementioned distance L₁ can be measured by a metal microscope or the like, as will be described later.

In the present invention, the term "bottom of the breaker surface" means the lowest position of the breaker surface 22 when the bottom of the breaker surface 22 is not flat (The cross-sectional shape including the breaker surface 22 is measured. When the cutting edge is located at the corner part as viewed from the rake face, the measurement is carried out at the center of the corner part.). On the other hand, when the bottom of the breaker surface 22 is flat, the term "bottom of the breaker surface" means the central position of the flat part. The term "the middle region of the cutting edge" means a top portion 5a when the cutting edge 5 is viewed from the direction indicated by the arrow I, which forms 45° with respect to the rake face 3 as viewed in cross-section, provided that the rake face 3 is a surface orthogonal to the thickness direction of the tool 21, as shown in Fig. 7.

The mean depth of the recessed portions 27 in the region Lₐ between the end on the rake face 3 of the cutting edge 5 and the bottom of the breaker surface 22 is 0.1 to 2µm, preferably 0.3 to 1.0µm. This enables the coolant to be held efficiently by the recessed portions 27, thereby suppressing the oxidation wear of the rake face 3. That is, when the mean depth of the recessed portions 27 is 0.1µm and above, the oxidation wear of the rake face 3 can be suppressed. When the mean depth of the recessed portions 27 is 2µm or less, the layer peeling of the coating layer 26 can be reduced.

The mean depth of the recessed portions 27 in the cutting edge 5 is 0.05 to 1µm, preferably 0.1 to 0.5µm. This reduces the fracture originated from the recessed portions 27. That is, when the mean depth of the recessed portions 27 is 0.05µm and above, the deterioration of chip discharge properties can be suppressed. When the mean depth of the recessed portions 27 is 1 µm or less, the occurrence of fracture under the impact of the work material can be suppressed.

The mean depth of the recessed portions 27 can be obtained as follows. As will be described later, three to six locations on a predetermined surface of the coating layer 26 are measured by an atomic force microscope (AFM) using a senserlever of a carbon nanotube or the like, and a mean value of the measured values may be used as a mean depth of the recessed portions 27.

The total layer thickness of the coating layer 26 is preferably 3 to 35µm. This enables suppression of the occurrence of peeling and chipping of the coating layer 26. That is, when the total layer thickness is 3µm and above, it is possible to suppress the deterioration of wear resistance of the tool 21. When the total layer thickness is within 35µm, it is possible to suppress the deterioration of fracture resistance of the coating layer 26. The total layer thickness of the coating layer 26 can be measured from the cross-sectional SEM photograph of the coating layer 26, as will be described later. The total layer thickness of the coating layer 26 is preferably in the range of 4 to 20µm.

The area ratio of the recessed portions 27 in a region L_{b} extending inward from the bottom of the breaker surface 22 in the rake face 3 is 30 to 95%, preferably 40 to 70%. This further improves the abovementioned lubricity and suppresses the oxidation wear of the rake face 3. That is, the area ratio of 30% and above can suppress the oxidation wear of the rake face 3, and the area ratio of 95% or less can suppress the deterioration of the wear resistance of the coating layer 26.

The arithmetic mean roughness Ra of the surface of the coating layer 26 in the middle region of the cutting edge 5 is 0.05 to 0.4µm, preferably 0.1 to 0.3µm. This provides smoothness for the chip flow region, thus improving chip discharge properties.

Next, the method of manufacturing the abovementioned tool 21 according to the second preferred embodiment will be described below. Like the first preferred embodiment, firstly, a substantially flat substrate 2 is prepared. To a portion of the substrate 2 which corresponds to a cutting edge 5, horning process using a brush and a grindstone is carried out to form a region 14 (a horning portion) after being subjected to cutting edge reinforcement process.

Subsequently, with CVD method, a coating layer 26 having the same layer configuration as the coating layer 6 of the first preferred embodiment is coated similarly to the first preferred embodiment on the surface of the substrate 2 subjected to the horning process. When the coating layer 26 has a layer configuration other than that of the coating layer 6, the respective layers may be formed under the following layer forming conditions. That is, for example, a titanium nitride (TiN) layer may be formed by preparing, as a reaction gas composition, a mixed gas composed of 0.1 to 10% by volume of titanium chloride (TiCl₄) gas, 0.1 to 60% by volume of nitrogen (N₂) gas, and the rest which is hydrogen (H₂) gas. The mixed gas is then admitted into a reaction reactor in the range of 800 to 1100°C and 5 to 85kPa.

A titanium carbonitride (TiCN) layer may be formed by preparing, as a reaction gas composition, a mixed gas composed of 0.1 to 10% by volume of titanium chloride (TiCl₄) gas, 0.1 to 60% by volume of nitrogen (N₂) gas, 0 to 0.1 % by volume of methane (CH₄) gas, 0.1 to 3% by volume of acetonitrile (CH₃CN) gas, and the rest which is hydrogen (H₂) gas. The mixed gas is then admitted into a reaction reactor in the range of 800 to 1100°C and 5 to 85kPa.

A titanium carbide (TiC) layer may be formed by preparing, as a reaction gas composition, a mixed gas composed of 0. to 30% by volume of TiCl₄ gas, 0.1 to 20% by volume of CH₄ gas and the rest which is H₂ gas. The mixed gas is then admitted into a reaction reactor in the range of 800 to 1100°C and 5 to 85kPa.

A titanium oxycarbonitride (TiCNO) layer may be formed by preparing, as a reaction gas composition, a mixed gas composed of 0.1 to 3% by volume of TiCl₄ gas, 0.1 to 10% by volume of CH₄ gas, 0.1 to 60% by volume of N₂ gas, 0.3 to 1.2% by volume of CO₂ gas and the rest which is H₂ gas. The mixed gas is then admitted into a reaction reactor in the range of 800 to 1100°C and 5 to 85kPa.

An aluminum oxide (Al₂O₃) layer may be formed by preparing, as a reaction gas composition, a mixed gas composed of 3 to 20% by volume of aluminum chloride (AlCl₃) gas, 0.5 to 3.5% by volume of hydrogen chloride (HCl) gas, 0.01 to 5.0% by volume of CO₂ gas, 0 to 0.05% by volume of hydrogen sulfide (H₂S) gas, and the rest which is H₂ gas. The mixed gas is then admitted into a reaction reactor in the range of 900 to 1100°C and 5 to 10kPa.

Subsequently, the surface of the coating layer 26 thus formed is ground so that the recessed portions 27 can be more scattered in the rake face 3 than in the cutting edge 5. That is, the polishing is carried out so that the area ratio of a plurality of the recessed portions 27 in the rake face 3 can be greater than that in the cutting edge 5. No special limitation is imposed on the polishing process as long as the polishing permits scattering of the recessed portions 27 at a predetermined ratio. In the present invention, it is particularly preferred that the polishing consists of the following first and second polishing processes. This enables the recessed portions 27 to exist more in the rake face 3 than in the cutting edge 5.

Specifically, in the first polishing process, the surface of the coating layer 26, which includes at least the rake face 3 and the cutting edge 5, is firstly ground so that the recessed portions 27 can be scattered in the surface of the coating layer 26. The polishing time depends on the material of the coating layer 26 and the tool shape, and it may be usually about 10 to 500 seconds, preferably about 30 to 240 seconds.

Subsequently, in the second polishing process, only the coating layer 26 in the cutting edge 5 is further ground with a mask put on the coating layer 26 in the rake face 3. In this case, the polishing time of the cutting edge 5 is preferably 0.1 to 1.5 times greater than that in the first polishing process.

The first and second polishing processes may be carried out with a brush containing grinds (#100 to 1600) of diamond, aluminum oxide, silicon carbide (SiC) or the like. Examples of the brush include a wheel brush and a dot brush.
Otherwise, the configuration is identical to that described in the first preferred embodiment, and the description thereof is therefore omitted here.

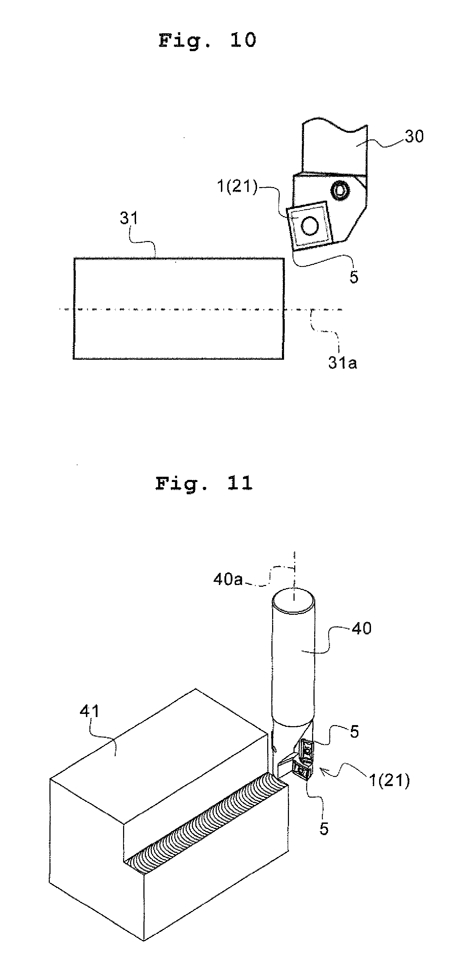

Next, the method of manufacturing work pieces according to the present invention will be described in detail with reference to the accompanying drawings. Fig. 10 is an explanatory drawing showing an example of the method of manufacturing work pieces according to the present invention. Fig. 1 is a perspective view showing other example of the method of manufacturing work pieces according to the present invention. In Figs. 10 and 11, the same reference numerals have been used as in the abovementioned configurations of Figs. 1 to 9 for identical or similar components, and the description thereof is therefore omitted here.

The method of manufacturing work pieces according to the present invention includes the step of bringing the cutting edge 5 of the cutting tool 1 (21), as described above, into contact with the surface of a work material (for example, a metal work to be cut); and the step of obtaining work pieces by cutting the work material by causing relative movement of the work material and the cutting edge. Examples of the cutting include turning process in which the work material is rotated, and milling process in which the cutting tool is rotated. Particularly, turning process is preferred.

That is, in the turning process, as shown in Fig. 10, the tool 1 (21) is attached to a holder 30, and a work material 31 is rotated around an axis 31a of the work material 31. Desired work pieces can be obtained by cutting the work material 31 in a desired shape by causing relative movement of the work material 31 and the cutting edge 5 while bringing the cutting edge 5 of the tool 1 (21) into contact with the surface of the work material 31.

In the milling process, as shown in Fig. 11, the tool 1 (21) is attached to a holder 40, and is being rotated around an axis 40a of the holder 40. Desired work pieces can be obtained by cutting the work material 41 in a desired shape by causing relative movement of the work material 41 and the cutting edge 5 while bringing the cutting edge 5 of the tool 1 (21) into contact with the surface of the work material 41.

In either process, when the cutting tool is formed by the tool 1, work pieces having good finished surface can be stably obtained in high speed cutting or dry cutting, because the tool 1 has both of the welding resistance and wear resistance. When the cutting tool is formed by the tool 21, work pieces having good finished surface can be stably obtained as in the case with the tool 1, because the tool 21 has high lubricity against work material and excellent wear resistance and excellent fracture resistance.

The present invention will be described in more detail based on the following Examples, which are cited merely by way of example and without limitation.

### Example I

### Manufacturing of Cutting Tools

A mixture was obtained by mixing 88.5% by mass of tungsten carbide (WC) powder having a mean grain size of 1.5 µm, 6% by mass of metal cobalt (Co) powder having a mean grain size of 1.2µm, 0.5% by mass of titanium carbide (TiC) powder having a mean grain size of 2.0µm, and 5% by mass of TaC powder having a mean grain size of 2.0µm.

The above mixture was then press-formed into a cutting tool shape (CNMG120408). This was then subjected to debinding process, followed by sintering in vacuum of 0.01 Pa at 1500°C for one hour, thereby manufacturing cemented carbide. The cemented carbide was further subjected to cutting edge reinforcement process (honing R) by brushing from the rake face.

Then, various coating layers were formed on this cemented carbide by CVD method. Specifically, a coating layer consisting of a multilayer having the configuration as shown in Table 2 was formed under coating conditions as shown in Table 1. After coating the coating layer, the surface of each sample was ground by the polishing method as shown in Table 2, so that the outermost layer was adjusted to a layer thickness as presented in Table 2, thereby manufacturing the cutting tools of Sample Nos. I-1 to 1-9.

The surface of the coating layer of the cutting tool thus obtained was observed with a metal microscope at a magnification ×1000, and confirmed the presence of a plurality of first phases composed of aluminum oxide and a second phase composed of titanium nitride, namely, the surface configuration that a plurality of the first phases composed of aluminum oxide were exposed and the second phase composed of titanium nitride was exposed so as to surround the first phases in the surface of the coating layer (the outermost layer). Subsequently, the observation image was analyzed by an image analyzer "LUZEX FS type" manufactured by NIRECO CORPORATION, and the area ratio of the first phases composed of aluminum oxide was measured with respect to the breaker surface 12 and the land surface 13, respectively. The results are presented in Table 2.

The term "the surface configuration" in Table 2 means the surface configuration that a plurality of the first phases composed of aluminum oxide are present in the second phase composed of titanium nitride in the surface of the coating layer, namely, the surface configuration that a plurality of the first phases composed of aluminum oxide are scattered and exposed, and the second phase composed of titanium nitride is exposed so as to surround the first phases. The symbol "○" means achievement of the abovementioned surface configuration, and the symbol "×" means non-achievement of the abovementioned surface configuration.

The surface roughness (maximum height roughness Rz and arithmetic mean roughness Ra) of the outermost layer surface in the land surface 13 of the cutting tool was measured with a probe type surface roughness meter according to JIS B0601'01, under the conditions of 0.25 mm in cutoff value, 0.8mm in reference length and 0.1mm/sec in scanning speed. The results are presented in Table 2.

The coating layer of the obtained cutting tool was observed at a magnification ×500,000 by using a transmission electron microscope (TEM), and the grain sizes of aluminum oxide particles and titanium nitride particles in the surface of the outermost layer were measured, respectively, by using the image analyzer "LUZEX FS type" manufactured by NIRECO CORPORATION. Specifically, the areas of individual particles were calculated and a mean value thereof was obtained. The mean value was then converted to a circle having the same area, and the diameter of the circle was used as a mean grain size. The results are presented in Table 2.

**[Table 1]**

| Coating layer | Composition of mixed gas (% by volume) | Flow rate of forming mixed gas (L/min) | Layer forming temperature (°C) | Pressure (kPa) |
|---|---|---|---|---|
| TiN1 | TiCl₄:0.5.N₂:33,H₂:The rest | 30 | 970 | 16 |
| TiN2 | TiCl₄:0.5,N₂:44,H₂:The rest | 50 | 1000 | 12 |
| TiCN1 | TiCl₄:1.0,N₂:43,CH₃CN:O.3,H₂:The rest | 70 | 860 | 10 |
| TiCN2 | TiCl₄:1.0,N₂:43,CH₄:4,H₂:The rest | 50 | 1000 | 10 |
| TiCNO | TiCl₄:0.7,CH₄:4,N₂.5,CO₂:1.0,H₂:The rest | 35 | 1010 | 10 |
| TiCO | TiCl₄:0.7,CH₄:4,CO₂:1.2,H₂:The rest | 35 | 1010 | 10 |
| TiNO | TiCl₄:0.7,CH₄:4,N₂:5,CO₂:1.1,H₂:The rest | 35 | 1010 | 10 |
| TiC | TiCl₄:1.0,CH₄:6,H₂:The rest | 65 | 1000 | 10 |
| Al₂O₃1 | AlCl₃:15,HCl:2,CO₂:4,H₂S:0.01,H₂:The rest | 50 | 1020 | 6 |
| Al₂O₃2 | AlCl₃:15.HCl:2,CO₂:4,H₂S:0.01,H₂:The rest | 10 | 990 | 6 |

**[Table 2]**

| Sample No.¹⁾ | Coating layer²⁾ | | | | | | Polishing process | | | Surface configuration | Area ratio of Al₂O₃ phase | | Mean grain size (µm) | | Surface roughness | |
|---|---|---|---|---|---|---|---|---|---|---|---|---|---|---|---|---|
| | Under layer | | | | | Outermost layer³⁾ | Method | Grain | Projecting length (cm) | | Land surface(%) | Breaker surface(%) | TiN phase | Al₂O₃ phase | Rz (µm) | Ra (µm) |
| | First layer | Second layer | Third layer | Fourth layer | Fifth layer | | | | | | | | | | | |
| I - 1 | TiN1 (0.5) | TiCN1 (9.0) | TiCNO (0.5) | Al₂O₃1 α-Al₂O₃ (2.0) | - | TiN1 (2.0→0.5) [0.08] | Brush | Diamond (#3000) | 5 | ○ | 8.0 | 10.3 | 0.08 | 1.2 | 0.81 | 0.12 |
| I - 2 | TiN1 (0.6) | TiCN1 (3.0) | TiN2 (0.5) | TiCNO (0.1) | Al₂O₃1 α-Al₂O₃ (4.0) | TiN1 (1.5→0.2) [0.05] | Brush | Diamond (#3000) | 7 | ○ | 11.2 | 12.0 | 0.05 | 7 .8 | 0.71 | 0.04 |
| I - 3 | TiN1 (1) | TiON1 (5.0) | TiNO (0.3) | Al₂O₃1 α-Al₂O₃ (2.0) | TiCN2 (1.0) | TiN1 (1.0→0.3) (0.12) | Brush | Diamond (#1000) | 3.5 | ○ | 6.6 | 8.1 | 0.12 | 2.0 | 0.91 | 0.17 |
| I - 4 | TiCN1 (0.5) | TiCN2 (7.0) | TiCNO (0.1) | Al₂O₃1 α-Al₂O₃ (5.0) | - | TiN1 (2.0→1.0) [1.0] | Brush | Diamond (#500) | 3 | ○ | 5.8 | 6.5 | 1.0 | 1.1 | 1.46 | 0.30 |
| I - 5 | TiN1 (0.6) | TiCN1 (7.0) | TiCNO (0.3) | Al₂O₃1 α-Al₂O₃ (5.0) | - | TiN1 (2.0→1.0) [1.0] | Brush | Diamond (#1000) | 1 | ○ | 4.4 | 5.9 | 1.0 | 2.8 | 1.10 | 0.25 |
| I - 6 | TiCN1 (1.0) | TiCN2 (6.0) | | Al₂O₃1 κ-Al₂O₃ (4.0) | - | TiN1 (2.0→1.0) [1.0] | Brush | Diamond (#2000) | 2-5 | ○ | 5.1 | 5.7 | 1.0 | 1,6 | 0.72 | 0.11 |
| *I - 7 | TiN1 (0.6) | TiCN1 (3.3) | TiCNO (0.3) | Al₂O₃2 α-Al₂O₃ (5.0) | - | TiN1 (2.0→1.8) [1.0] | Brush | Al₂O₃ (#1000) | 0.3 | × | 0.0 | 0.0 | - | - | 2.21 | 0.93 |
| *I - 8 | TiCN1 (3.3) | TiCNO (0.5) | Al₂O₃1 (3.0) | - | - | TiN2 (2.0→1.5) [2.5] | Brush (#2000) | Diamond | 10 | × | 0.0 | 0.0 | - | - | 1.32 | 0.50 |
| *I - 9 | TiN1 (0.6) | TiCN1 (7.0) | TiCNO (0.5) | Al₂O₃2 α, κ-Al₂O₃ (7.0) | - | TiN2 (6.0→0.0) [0.005] | Barrel process | sic (#1000) | - | × | 0.0 | 0.0 | - | - | 0.27 | 0.03 |

| | | | | | | | | | | | | | | | | |
|---|---|---|---|---|---|---|---|---|---|---|---|---|---|---|---|---|
| 1) The samples marked "*" are out of the scope of the present invention. 2) ( ) stands for layer thickness, and [ ] stands for grain size. Unit: µm 3) As for numbers in ( ) of the outermost layer field, the number on the left stands for layer thickness of the rake face right after layer formation, and the number on the right stands for layer thickness of the rake face after grinding. | | | | | | | | | | | | | | | | |

### Evaluations of Wear Resistance and Fracture Resistance

Under the following conditions, the continuous cutting test of the respective cutting tools obtained above was conducted to evaluate wear resistance and fracture resistance. The results are presented in Table 3.

### Continuous Cutting Conditions

Work material: SCM440, cylindrical material
Tool shape: CNMG120408
Cutting speed: 350m/min
Feed rate: 0.4mm/rev
Depth of cut: 2mm
Cutting time: 20 minutes
Cutting condition: Wet cutting
Evaluation items: The cutting edge was observed by a metal microscope, flank wear amount and crater wear depth were measured, and the cutting edge after five-minute cutting was observed.

**[Table 3]**

| Sample No.¹⁾ | Wear test: Wear amount (mm) | | Condition of coating layer |
|---|---|---|---|
| | Flank wear | Crater wear | |
| I - 1 | 0.14 | 0.06 | No damage |
| I - 2 | 0.15 | 0.09 | No damage |
| I - 3 | 0.18 | 0.1 | No damage |
| I - 4 | 0.20 | 0.11 | No damage |
| I - 5 | 0.20 | 0.14 | No damage |
| I - 6 | 0.22 | 0.15 | No damage |
| * I - 7 | 0.29 | 0.33 | Chipping |
| * I - 8 | 0.28 | 0.3 | Chipping |
| * I - 9 | 0.35 | 0.28 | Chipping due to welding |

| | | | |
|---|---|---|---|
| 1) The samples marked "*" are out of the scope of the present invention. | | | |

The following will be noted from Tables 1 to 3. That is, in Sample Nos. I-7 to I-9, in which no aluminum oxide phase was scattered in the surface of the outermost layer composed of titanium nitride, in other words, the non-achievement of the surface configuration that the plurality of the first phases composed of aluminum oxide were present in the second phase composed of titanium nitride, the tool wear progressed quickly, and the tool life was extremely short due to the welding of the work material and the chipping caused by chip jamming. More specifically, in Sample Nos. I-7 and I-8, in which polishing was insufficient and no phase composed of aluminum oxide was exposed in the outermost layer surface, namely the surface of the coating layer, due to the absence of the oxidation resistance owing to aluminum oxidation, the tool surface temperature was particularly raised, and the breaker surface apt to oxidation was susceptible to wear, resulting in a large value of crater wear. In Sample No. 1-9, in which the outermost layer was completely removed by polishing and the coating layer surface was composed only of aluminum oxide, the welding resistance became insufficient, resulting in an especially large flank wear due to the welding of the work material on the land surface.

On the other hand, in Sample Nos. I-1 to I-6, in which titanium nitride phases and aluminum oxide phases were scattered in the surface of the outermost layer, in other words, attaining the surface configuration that the plurality of the first phases composed of aluminum oxide were present in the second phase composed of titanium nitride, had excellent wear resistance in terms of crater wear and flank wear, and performed smooth chip discharge, causing little or not fracture due to chip jamming and the work material welding.

In every sample, the aluminum oxide phase (namely the first phase composed of aluminum oxide) had a greater area ratio in the breaker surface than in the land surface. This seems due to the cutting edge reinforcement process by brushing after manufacturing the substrate, which was common to the manufacturing steps of the respective samples. That is, the land surface located near the cutting edge can also be somewhat ground by the cutting edge reinforcement process. Therefore, at the time of polishing after the layer formation, the land surface and the breaker surface have different surface roughnesses, and the breaker surface having a rough surface, to which no polishing is applied, can be greatly ground by the polishing after the layer formation. As a result, the breaker surface permits more exposure of the aluminum oxide phase than the land surface. Since the area ratio of the aluminum oxide phase on the surface depends on the cutting edge reinforcement process before the layer formation, all of samples had substantially the same difference in the area ratio between the land surface and the breaker surface, irrespective of the layer composition and the surface roughness in the respective samples.

As shown in Table 2, the brushing is preferred in the abovementioned various polishing means. For example, the barrel process of Sample No. I-9, the outermost layer was almost removed, failing to obtain the effect of the present invention. It is therefore required to select polishing means and conditions so that the titanium nitride phase and the aluminum oxide phase can coexist in the surface of the outermost layer, namely the surface of the coating layer. The formation of the abovementioned surface configuration of the outermost layer provides excellent wear resistance, and the smoothness of the coating layer surface can be improved by the polishing process, thereby further improving the wear resistance. For example, in Sample No. 1-7, the brush had a projecting length of 0.3cm, and both of the maximum height roughness Rz and the arithmetic mean roughness Ra had a large value, and the surface having poor smoothness was susceptible to crater wear.

### Example II

### Manufacturing of Cutting Tools

There was prepared a substrate having the shape of CNMG120408 composed of cemented carbide in which tungsten carbide (WC) particles having a mean grain size of 1.5µm were bonded with cobalt (Co) (The bottom depth of the breaker surface at the central position of the nose R of the corner part was 0.5mm with respect to the end of the rake face of the cutting edge). A grindstone of grade No. 400, in which abrasive grains were dispersed into a soft resin member, was mounted on the rake face of the substrate, and R horning was carried out.

Onto the surface of the substrate after being subjected to the R homing, a coating layer was coated by CVD method under the coating conditions presented in Table 4 and the construction presented in Table 5. The surface of the coating layer was further ground under the polishing conditions presented in Table 5, thereby manufacturing cutting tools, respectively (Sample Nos. II-1 to II-8 in Table 5).

The above substrate had a land surface presented in Table 5 between the end on the rake face of the cutting edge and the breaker surface, and the bottom of the breaker surface had no flat part. The total layer thickness of the coating layer was measured by using a cross-sectional SEM photograph of the coating layer. In Table 5, the expression "the first polishing process" in "the polishing process" means that the coating layer surface in the rake face and that in the cutting edge were ground for a polishing time presented in Table 5, respectively. The term "the second polishing process" means that after the first polishing process, only the coating layer in the cutting edge was further ground with a mask put on the coating layer in the rake face, for a polishing time presented in Table 5.

The arithmetic mean surface roughness Ra of the coating layer surface in the middle region of the cutting edge, the mean depth and the area ratio of recessed portions in the middle region of the cutting edge, the distance L₁ between the end on the rake face of the cutting edge and the bottom of the breaker surface, and the mean depth and the area ratio of recessed portions in the region extending from the end on the rake face of the cutting edge to the distance of (1/4) L₁ were measured by the following methods, respectively.

### Arithmetic Mean Roughness Ra

The surface roughness (the maximum height roughness Rz and the arithmetic mean roughness Ra) of the outermost surface (namely the surface of the coating layer) in a flat part such as the land in the vicinity of the cutting edge of the tool was measured as follows. That is, with a probe type surface roughness meter, the surface roughnesses at three locations in the middle region of the cutting edge before and after polishing process were measured according to JIS B0601'01 under the conditions of 0.25 mm in cutoff value, 0.8mm in reference length and 0.1mm/sec in scanning speed. The mean value of the measured values was used to express the surface roughness. The results are presented as "cutting edge Ra" in Table 5.

### Mean Depth of Recessed Portions of Cutting Edge

Three locations on the coating layer surface in the middle region of the cutting edge were measured by an atomic force microscope (AFM) using a senserlever of a carbon nanotube, and the mean value of the measured values was used as a mean depth of the recessed portions in the middle region of the cutting edge. The results are presented as "recess depth" in the "cutting edge" in Table 5.

### Area Ratio of Recessed Portion of Cutting Edge

The surface of the coating layer in the cutting tool was magnified 3000 times by a scanning electron microscope (SEM), and image data thereof were digitalized. The image data were subjected to computer image processing by using the image analysis software "imagePROGRAF" manufactured by Planetron, Inc., thereby obtaining the total area of the recessed portions in the image and the area of the recessed portions in the middle region of the cutting edge. The ratio of the area of the recessed portions in the middle region of the cutting edge to the total area was obtained. The results are presented as "recess area" in "cutting edge" in Table 5.

### Distance L₁

The distance L₁ between the end of the rake face of the cutting edge and the bottom of the breaker surface, when viewed from the cross-section in the middle of a corner R of the cutting tool, was measured by using a metal microscope. The results are presented as "L₁" in "L₁/4 part" in Table 5.

### Mean Depth of Recessed Portions in (1/4) L₁

The distance from the end on the rake face of the cutting edge to (1/4) L₁ was calculated from the distance L₁ measured above. The mean depth of the recessed portions in the region of (1/4) L₁ was measured similarly to the above mean depth of the recessed portions in the cutting edge. The results are presented as "recess depth" in "L₁/4 part" in Table 5.

### Area Ratio of Recessed Portions in (1/4) L₁

Similarly to the area ratio of the recessed portions in the cutting edge, the area of the recessed portion in the region of (1/4) L₁ was obtained, and the ratio of the area of the recessed portion in the region of (1/4) L₁ to the total area was calculated. The results are presented as "recess area" in "L₁/4 part" in Table 5.

**[Table 4]**

| Coating layer | Composition of mixed gas (% by volume) | Flow rate of mixed gas (L/min) | Layer forming temperature (°C) | Pressure (kPa) |
|---|---|---|---|---|
| TiN1 | TiCl₄:0.5,N₂:33,H₂: The rest | 30 | 970 | 16 |
| TiN2 | TiCl₄:2,N₂:33,H₂:The rest | 30 | 1050 | 16 |
| TiN3 | TiCl₄:0.2,N₂;33,H₂:The rest | 30 | 900 | 16 |
| TiCN1 | TiCl₄:1.0,N₂:43,CH₃CN:0.3,H₂:The rest | 70 | 860 | 10 |
| TiCN2 | TiCl₄:1,0,N₂:43,CW₄:4,H₂:The rest | 50 | 1000 | 10 |
| TiCNO | TiCl₄:0.7,CH₄:4,N₂:5,CO₂:1.0,H₂:The rest | 35 | 1010 | 10 |
| Al₂O₃ | AlCl₃:15,HCl:2,CO₂:4,H₂S:0.01,H₂:The rest | 50 | 1020 | 6 |

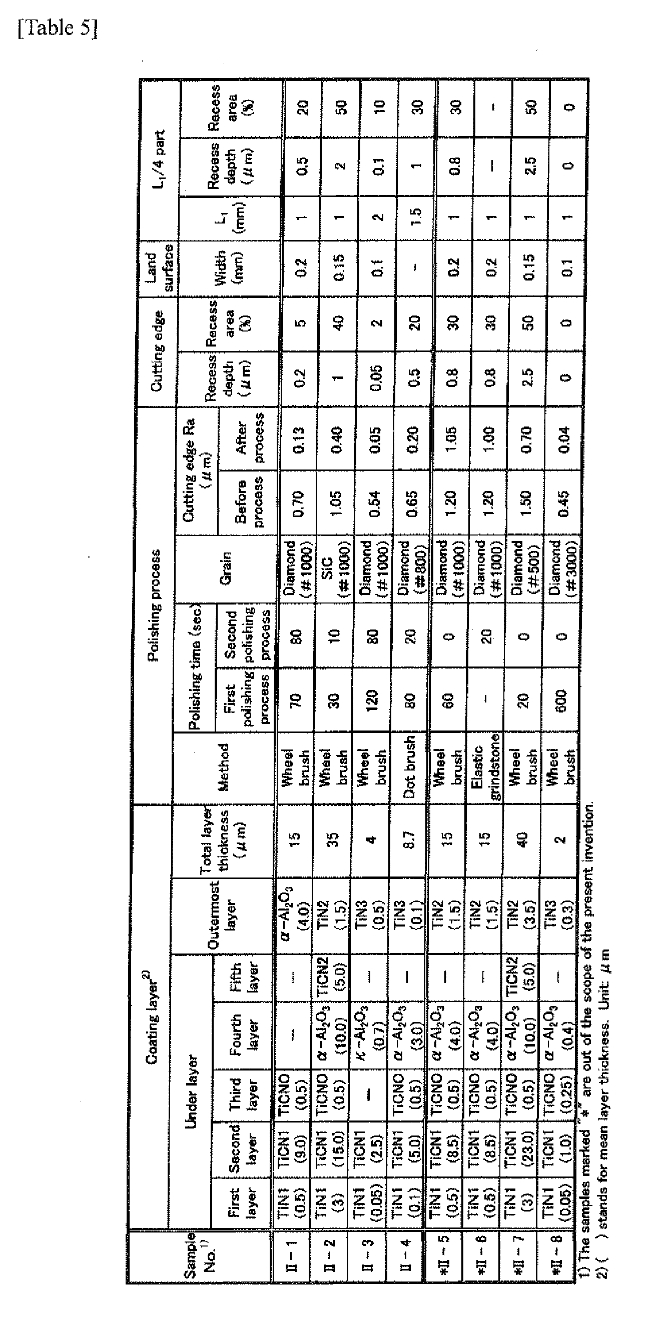

### Evaluations of Wear Resistance and Fracture Resistance

The wear resistances and the fracture resistances of the cutting tools obtained above (Sample Nos. II-1 to II-8 in Table 5) were evaluated by using the following methods, respectively. The results are presented in Table 6.

### Evaluation Method of Wear Resistance

Cutting speed: 300 m/min
Depth of cut: 2 mm
Feed rate: 0.3 mm/rev
Work material: SCM440
Cutting condition: Use of water-soluble coolant
Cutting time: 10 minutes
Evaluation item: After cutting, the crater wear depth was observed by a metal microscope. Specifically, the depth of the crater wear occurred in the coating layer surface after the cutting test was measured by the metal microscope. The cutting test was conducted by using three cutting tools, and the mean value of the measured values of the respective tools was used as the crater wear depth.

### Evaluation Method of Fracture Resistance

Cutting speed: 150m/min
Depth of cut: 3 mm
Feed rate: 0.4 mm/rev
Work material: SCM440 with four grooves
Cutting condition: Use of water-soluble coolant Evaluation item: The number of impacts until the occurrence of fracture was counted. Specifically, the cutting test was conducted by using 10 cutting tools. The fracture rate (%) was calculated by introducing the number of fracture occurrences into the following equation: (Number of cutting tools subjected to fracture/10) × 100.

**[Table 6]**

| Sample No.¹⁾ | Wear resistance | Fracture resistance |
|---|---|---|
| | Depth of crater ware (mm) | Fracture rate (%) |
| II - 1 | 0.1 | 10 |
| II - 2 | 0.05 | 40 |
| II - 3 | 0.1 | 0 |
| II - 4 | 0.07 | 20 |
| *II - 5 | 0.15 | 100 |
| *II - 6 | 0.17 | 90 |
| *II - 7 *II - 8 | 0.05 | 80 |
| | 0.25 | 0 |

| | | |
|---|---|---|
| 1) The samples marked "*" are out of the scope of the present invention. | | |

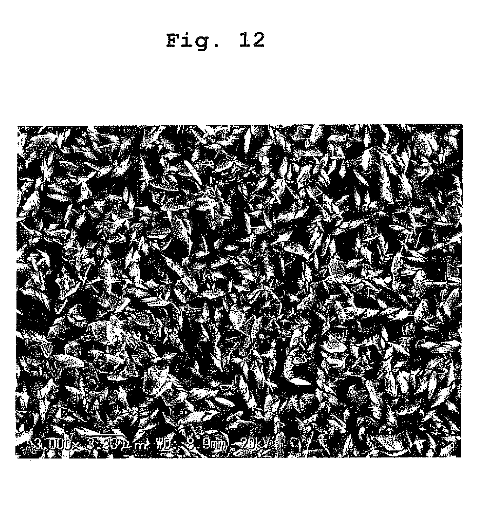

It will be noted from Table 6 that the cutting tools of Sample Nos. II-1 to II-4 had excellent wear resistance and excellent fracture resistance. On the other hand, the cutting tools of Sample Nos. II-5 to II-8 exhibited poor wear resistance and poor fracture resistance. In Sample No. II-6, in which only the cutting edge in the surface of the coating layer was ground, the surface of the coating layer in the non-grounded rake face had an uneven shape as a whole, as shown in Fig. 12, failing to obtain the surface having recessed portions.

### Example III

### Manufacturing of Cutting Tools

Similarly to Example I, the cutting tools of Sample Nos. I-1 to I-9 were manufactured. Sample Nos. III-1 to III-6 were obtained by applying the second polishing process of Sample No. II-2 to Sample Nos. I-1 to I-6, and Sample Nos. III-7 to III-9 were obtained by applying the second polishing process of Sample No. II-6 to Sample Nos. I-7 to I-9, respectively.

The area ratios of the respective phases and the area ratios of recessed portions in the cutting tools obtained above were measured by the abovementioned corresponding methods. The results are presented in Table 7.

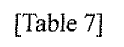

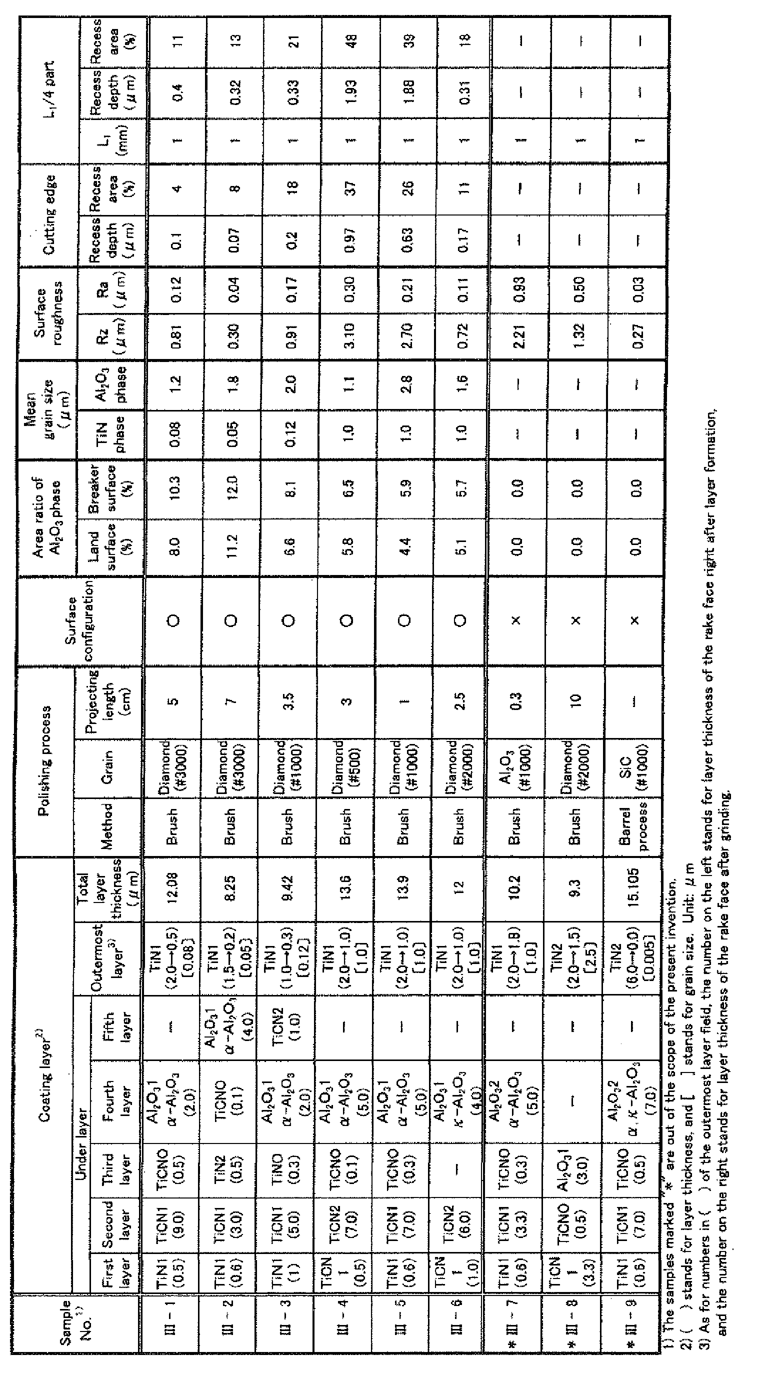

### Evaluations of Wear Resistance and Fracture Resistance

The wear resistance and the fracture resistance of the cutting tools obtained above were evaluated by using the same wear resistance evaluation method as Example I, and the same fracture resistance evaluation method as Example II, respectively. The results are presented in Table 8.

**[Table 8]**

| Sample No.¹⁾ | Wear test: Wear amount (mm) | | Fracture resistance | Condition of coating layer |
|---|---|---|---|---|
| | Flank wear | I Crater wear | Fracture rate (%) | |
| III - 1 | 0.14 | 0.07 | 10 | No problems |
| III - 2 | 0.15 | 0.05 | 40 | No problems |
| III - 3 | 0.20 | 0.12 | 0 | No problems |
| III - 4 | 0.18 | 0.07 | 20 | No problems |
| III - 5 | 0.20 | 0.1 | 25 | No problems |
| III - 6 | 0.22 | 0.06 | 33 | No problems |
| * III - 7 | 0.29 | 0.27 | 100 | Chipping |
| * III - 8 | 0.28 | 0.36 | 90 | Chipping |
| * III - 9 | 0.35 | 0.37 | 80 | Layer peeling |

| | | | | |
|---|---|---|---|---|
| 1) The samples marked "*" are out of the scope of the present invention. | | | | |

It will be noted from Tables 7 and 8 that the cutting tools of Sample Nos. III-1 to III-6 had excellent wear resistance and excellent fracture resistance because these samples had the abovementioned surface configuration and the recessed portions were scattered in the rake face and the cutting edge at a predetermined ratio.

On the other hand, the cutting tools of Sample Nos. III-7 to III-9 had poor wear resistance and poor fracture resistance, causing chipping and layer peeling, because these samples did not have the abovementioned surface configuration and no recessed portions was present in the rake face and the cutting edge.

While the preferred embodiments of the present invention have been described and illustrated above, it is to be understood that the invention is not limited to the above preferred embodiments and applicable to those in which modification and improvements are made thereto without departing from the gist of the invention. For example, although the foregoing embodiments are directed to the cases where the surface coated member is applied to cutting tools, the use of the surface coated member of the invention is not limited thereto. The surface coated member produces significant effects when applied to milling cutting tools, rotating tools such as drills and end mills, as well as wear resistance tools having purposes other than cutting, such as punches, dies and slitters, That is, the punches and the slitters have a region adjacent to the edge corresponding to the land surface of the cutting tool, and the dies have a large surface through which a work material is slid. Therefore, the surface coated member of the invention having both of welding resistance and wear resistance can also produce excellent effects in these types of tools.

The invention is not limited to the cutting tools according to the first and second preferred embodiments, respectively. Alternatively, the invention may be applied to a cutting tool according to a preferred embodiment as a combination of the first and second preferred embodiments. The cutting tool thus combined has excellent cutting oil retention owing to the recessed portions, in addition to the wear resistance and fracture resistance which can be exhibited by having the abovementioned surface configuration. It is therefore possible to achieve excellent lubricity and still further improvement of fracture resistance. This provides particularly excellent cutting performance in wet process.

## Claims

1. A surface coated member comprising a substrate and a coating layer to be formed on a surface of the substrate,
wherein a plurality of first phases and a second phase are present in a surface of the coating layer,
the plurality of first phases comprising at least one compound containing at least one element selected from the group consisting of metals in Groups 4, 5 and 6 of the periodic table, aluminum and silicon, and oxygen, and
the second phase comprising at least one compound selected from carbide, nitride and carbon nitride of at least one element selected from the group consisting of metals in Groups 4, 5 and 6 of the periodic table, aluminum and silicon.

2. The surface coated member according to claim 1, wherein the plurality of first phases are present within the second phase in the surface of the coating layer.

3. The surface coated member according to claim 2, wherein the plurality of first phases are connected to each other on the surface side of the substrate in a thickness direction of the coating layer.

4. The surface coated member according to any one of claims 1 to 3, wherein the first phases comprises aluminum oxide, and the second phase comprises titanium nitride.

5. The surface coated member according to claim 4, wherein the aluminum oxide particles constituting the first phases have a greater mean grain size than the titanium nitride particles constituting the second phase.

6. The surface coated member according to any one of claims 1 to 5, wherein the second phase accounts for a greater area than the first phases in the surface of the coating layer.

7. The surface coated member according to any one of claims 4 to 6, wherein a third phase is present in a boundary between the first phase and the second phase in the surface of the coating layer, and the third phase comprising titanium carbon nitride.

8. The surface coated member according to any one of claims 1 to 7, wherein the surface of the coating layer has a maximum roughness height Rz of 1.5µm or less.

9. A method of manufacturing a surface coated member comprising a substrate and a coating layer to be formed on a surface of the substrate, the method comprising the steps of:
forming on the surface of the substrate, as a layer constituting the coating layer, an under layer comprising at least one compound containing at least one element selected from the group consisting of metals in Groups 4, 5 and 6 of the periodic table, aluminum and silicon, and oxygen;
forming, as a surface layer of the coating layer, an outermost layer composed of at least one compound selected from carbide, nitride and carbon nitride of at least one element selected from the group consisting of metals in Groups 4, 5 and 6 of the periodic table, aluminum and silicon; and
polishing the outermost layer until a plurality of first phases constituting the under layer are exposed within a second phase constituting the outermost layer in the surface of the coating layer.

10. The method of manufacturing a surface coated member according to claim 9, wherein the under layer is an aluminum oxide layer, and the outermost layer is a titanium nitride layer.

11. The method of manufacturing a surface coated member according to claim 10, wherein the mean grain size of aluminum oxide particles constituting the aluminum oxide layer is greater than that of titanium nitride particles constituting the titanium nitride layer.

12. The method of manufacturing a surface coated member according to claim 10 or 11, further comprising the steps of:
forming a titanium carbon nitride layer as an inner layer adjacent to the titanium nitride layer; and
polishing until at least a part of the third phase composed of titanium carbon nitride particles constituting the titanium carbon nitride layer is exposed in the surface of the coating layer.

13. A cutting tool including a surface coated member according to any one of claims 1 to 8, the cutting tool being provided with a rake face formed on an upper surface, a flank face formed on a side surface, and a cutting edge formed at a crossed ridge portion between the rake face and the flank face, wherein the rake face is formed by at least the surface of the coating layer.

14. The cutting tool according to claim 13, wherein the rake face is provided with a land surface adjacent to the cutting edge, and a breaker surface adjacent to the land surface, and the first phase has a higher area ratio on the breaker surface than on the land surface.

15. The cutting tool according to claim 13 or 14, wherein the first phase on the land surface has an area ratio of 0.1 to 30, and the first phase on the breaker surface has an area ratio of 1 to 50.

16. The cutting tool according to any one of claims 13 to 15, wherein the coating layer is coated by a chemical vapor deposition method, and the surface of the coating layer has a plurality of recessed portions, the recessed portions accounting for a greater area ratio on the rake face than on the cutting edge.

17. The cutting tool according to any one of claims 13 to 16, wherein the recessed portions in a region between the end on the rake face side of the cutting edge and the bottom of the breaker surface account for a greater area ratio than on the cutting edge.

18. The cutting tool according to any one of claims 13 to 17, wherein the recessed portions in a region between the end on the rake face side of the cutting edge and the bottom of the breaker surface account for 10 to 50%, and the recessed portions in the cutting edge account for an area ratio of 2 to 40%,

19. The cutting tool according to any one of claims 13 to 18, wherein the recessed portions in a region between the end on the rake face side of the cutting edge and the bottom of the breaker surface have a mean depth of 0.1 to 2µm, and the recessed portions in the cutting edge have a mean depth of 0.05 to 1µm.

20. The cutting tool according to any one of claims 13 to 19, wherein the coating layer has a total layer thickness of 3 to 35µm.

21. The cutting tool according to any one of claims 13 to 20, wherein the recessed portions in a region extending inside of the bottom of the breaker surface on the rake face account for an area ratio of 30 to 95%.

22. A cutting tool in which at least one coating layer is coated by a chemical vapor deposition method on a surface of a substrate provided with a cutting edge at a crossed ridge portion between a rake face and a flank face, wherein a surface of the coating layer has a plurality of recessed portions, which account for a greater area ratio on the rake face than on the cutting edge.

23. The cutting tool according to claim 22, wherein the rake face has a breaker surface, and the recessed portions in a region between the end on the rake face side of the cutting edge and the bottom of the breaker surface account for a greater area ratio than in the cutting edge.

24. The cutting tool according to claims 22 or 23, wherein the recessed portions in a region between the end on the rake face side of the cutting edge and the bottom of the breaker surface account for 10 to 50%, and the recessed portions in the cutting edge account for an area ratio of 2 to 40%.

25. The cutting tool according to any one of claims 22 to 24, wherein the recessed portions in a region between the end on the rake face side of the cutting edge and the bottom of the breaker surface have a mean depth of 0.1 to 2µm, and the recessed portions in the cutting edge have a mean depth of 0.05 to 1µm.

26. The cutting tool according to any one of claims 22 to 25, wherein the recessed portions in a region extending inside of the bottom of the breaker surface on the rake face account for an area ratio of 30 to 95%.

27. A method of manufacturing work pieces, comprising the steps of:
bringing a cutting edge of a cutting tool according to any one of claims 13 to 26 into contact with a surface of a work material; and
obtaining work pieces by cutting the work material by causing relative movement between the work material and the cutting edge.
